# EUROPÄISCHE PATENTSCHRIFT

(11) **EP 3 162 173 B1**
(45) Veröffentlichungstag und Bekanntmachung des Hinweises auf die Patenterteilung: **17.08.2022**
(21) Anmeldenummer: 15726922.6
(22) Anmeldetag: 28.05.2015
(51) Int. Cl.: H05K 5/00, H05K 5/02, F25D 23/00, F25D 29/00

(54) **HAUSHALTSGERÄTEVORRICHTUNG**
DOMESTIC APPLIANCE DEVICE
APPAREIL MÉNAGER

(30) Priorität: 24.06.2014 DE 102014212098
(43) Veröffentlichungstag der Anmeldung: 03.05.2017
(73) Patentinhaber: BSH Hausgeräte GmbH, 81739 München (DE)
(72) Erfinder: GRÜNWALD, Matthias, 89537 Giengen (DE); KRAPP, Michael, 89564 Nattheim (DE); WERTS, Thomas, 89293 Kellmünz (DE)
(86) Internationale Anmeldenummer: PCT/EP2015/061794
(87) Internationale Veröffentlichungsnummer: WO 2015/197300

(56) Entgegenhaltungen:
- EP-A1- 1 463 393
- EP-A1- 2 095 573
- DE-A1-102004 052 621
- DE-A1-102012 209 815

## Beschreibung

Die Erfindung geht aus von einer Haushaltskältegerätevorrichtung nach dem Oberbegriff des Anspruchs 1.

Aus dem Stand der Technik ist bereits eine Haushaltsgerätevorrichtung bekannt mit einem Elektronikgehäuse und einem weiteren Elektronikgehäuse. Das Elektronikgehäuse ist hierbei in einem montieren Zustand in einer Abdeckplatte verbaut, die insbesondere als "Top-Panel" bezeichnet und insbesondere in einem oberen Bereich eines die Haushaltsgerätevorrichtung aufweisenden Haushaltsgeräts angeordnet ist. Das weitere Elektronikgehäuse ist in dem montierten Zustand getrennt von dem Elektronikgehäuse verbaut. Beispielsweise ist das weitere Elektronikgehäuse in dem montierten Zustand an einem Haushaltsgerätegehäuse, und zwar insbesondere an einer seitlichen Begrenzung eines Maschinenraums, befestigt. Alternativ ist bekannt, dass das weitere Elektronikgehäuse direkt an einer Tragschiene, welche in dem montierten Zustand einen Boden des Maschinenraums ausbildet, befestigt ist.

EP 1 463 393 A1 offenbart ein Halbleiterrelais mit einem im Wesentlichen quaderförmigen Gehäuse mit einem mechanischen Verbindungselement zum Anschluss eines Funktionsmoduls.

EP 2 095 573 A1 offenbart eine Vorrichtung zum Anschluss von Endgeräten an ein Breitbandnetzwerk, umfassend ein Gehäuse, einen Kabelanschlusspunkt sowie eine Abdeckung.

DE 10 2004 052 621 A1 offenbart ein Kältegerät, aufweisenden einen, einen Verdampfer, einen Verflüssiger und einen Verdichter umfassenden Kältekreislauf, sowie elektronische Komponenten zum Betrieb des Kältegerätes, wobei die elektronischen Komponenten zu einer Elektronikeinheit zusammengefasst sind.

Die Aufgabe der Erfindung besteht insbesondere darin, eine gattungsgemäße Vorrichtung mit verbesserten Eigenschaften hinsichtlich einer hohen Flexibilität bereitzustellen. Die Aufgabe wird erfindungsgemäß durch die kennzeichnenden Merkmale des Patentanspruchs 1 gelöst, während vorteilhafte Ausgestaltungen und Weiterbildungen der Erfindung den Unteransprüchen entnommen werden können.

Die Erfindung geht aus von einer Haushaltskältegerätevorrichtung mit zumindest einem Elektronikgehäuse.

Es wird vorgeschlagen, dass das zumindest eine Elektronikgehäuse zumindest ein Anschlusselement aufweist, das dazu vorgesehen ist, zumindest ein weiteres Elektronikgehäuse an dem zumindest einen Elektronikgehäuse zu befestigen, und das zumindest eine Elektronikgehäuse dazu vorgesehen ist, in wenigstens einem montierten Zustand das zumindest eine weitere Elektronikgehäuse wenigstens teilweise, vorzugsweise wenigstens zu einem wesentlichen Teil und besonders vorteilhaft vollständig zu tragen. Unter einer "Haushaltskältegerätevorrichtung" soll insbesondere zumindest ein Teil, insbesondere eine Unterbaugruppe, eines Haushaltskältegeräts verstanden werden. Insbesondere kann die Haushaltskältegerätevorrichtung auch das gesamte Haushaltskältegerät umfassen. Besonders vorteilhaft ist das Haushaltskältegerät dazu vorgesehen, in dem wenigstens einen Betriebszustand Kühlgut, insbesondere Lebensmittel wie beispielsweise Getränke, Fleisch, Fisch, Milch und/oder Milchprodukte, zu kühlen, insbesondere um eine längere Haltbarkeit der Kühlgüter zu bewirken. Bei dem Haushaltskältegerät kann es sich insbesondere um eine Kühltruhe und vorteilhaft um einen Kühl- und/oder Gefrierschrank handeln. Unter einem "Elektronikgehäuse" soll insbesondere eine Baueinheit verstanden werden, die wenigstens einen Großteil einer äußeren Begrenzung zumindest eines Hohlraums ausbildet und die wenigstens größtenteils den zumindest einen Hohlraum umschließt, welcher dazu vorgesehen ist, wenigstens in einem Betriebszustand zumindest eine Elektronikeinheit aufzunehmen, wie beispielsweise eine Steuereinheit und/oder eine Versorgungselektronik und/oder eine Energiequelle und/oder eine Drehzahlelektronik und/oder eine Regelelektronik. Es sind verschiedene, einem Fachmann als sinnvoll erscheinende Ausgestaltungen des zumindest einen Elektronikgehäuses und/oder des zumindest einen weiteren Elektronikgehäuses denkbar. Beispielsweise könnte zumindest eines der Elektronikgehäuse wenigstens ein Metall aufweisen, welches insbesondere elektrisch isoliert sein könnte, wie beispielsweise durch eine Beschichtung. Ebenfalls denkbar ist, dass zumindest eines der Elektronikgehäuse wenigstens eine Keramik aufweist. Vorzugsweise weist zumindest eines der Elektronikgehäuse und besonders vorteilhaft beide Elektronikgehäuse jedoch wenigstens einen Kunststoff auf. Unter einem "Anschlusselement" einer Baueinheit, insbesondere des zumindest einen Elektronikgehäuses und/oder des zumindest einen weiteren Elektronikgehäuses, soll insbesondere ein Element verstanden werden, das in dem wenigstens einen montierten Zustand wenigstens einen Teil zumindest einer weiteren Baueinheit, insbesondere des zumindest einen weiteren Elektronikgehäuses und/oder des zumindest einen Elektronikgehäuses, berührt und das insbesondere dazu vorgesehen ist, in dem wenigstens einen montierten Zustand wenigstens einen Punkt einer Position der weiteren Baueinheit relativ zu der Baueinheit zu definieren, insbesondere festzulegen. Das zumindest eine Anschlusselement des zumindest einen Elektronikgehäuses ist insbesondere dazu vorgesehen, in dem wenigstens einen montierten Zustand wenigstens einen Teil einer Gewichtskraft des zumindest einen weiteren Elektronikgehäuses aufzunehmen und diesen wenigstens einen Teil der Gewichtskraft weiterzuleiten. Unter der Wendung, dass das zumindest eine Elektronikgehäuse dazu vorgesehen ist, in wenigstens einem montierten Zustand das zumindest eine weitere Elektronikgehäuse wenigstens teilweise "zu tragen", soll insbesondere verstanden werden, dass das zumindest eine Elektronikgehäuse in dem wenigstens einen montierten Zustand eine Gewichtskraft des zumindest einen weiteren Elektronikgehäuses wenigstens teilweise aufnimmt und insbesondere die aufgenommene Gewichtskraft des zumindest einen weiteren Elektronikgehäuses an eine Haushaltskältegeräteeinheit wie beispielswiese an zumindest ein Haushaltskältegerätegehäuse an welcher die zumindest eine Elektronikeinheit in dem wenigstens einen montierten Zustand insbesondere befestigt ist, weiterleitet und überträgt. Unter der Wendung, dass das zumindest eine Elektronikgehäuse dazu vorgesehen ist, in wenigstens einem montierten Zustand das zumindest eine weitere Elektronikgehäuse "wenigstens zu einem wesentlichen Teil" zu tragen, soll insbesondere verstanden werden, dass das zumindest eine Elektronikgehäuse in dem wenigstens einen montierten Zustand einen Anteil von mindestens 94 %, insbesondere von mindestens 80 %, vorteilhaft von mindestens 90 % und vorzugsweise von mindestens 95 % der Gewichtskraft des zumindest einen weiteren Elektronikgehäuses trägt. Unter "vorgesehen" soll insbesondere speziell ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt. Durch die erfindungsgemäße Ausgestaltung kann insbesondere eine hohe Flexibilität erreicht werden. Darüber hinaus kann durch die direkt beieinander angeordneten Elektronikgehäuse auf lange Verbindungsleitungen verzichtet werden, wodurch geringe Kosten und/oder eine schnelle Montage erreicht werden können. Weiterhin kann durch eine kompakte Anordnung der Elektronikgehäuse ein geringer Platzbedarf der Elektronikgehäuse erreicht werden. Besonders vorteilhaft kann eine einfache und/oder schnelle und/oder flexible Befestigung zumindest der weiteren Elektronikeinheit erreicht werden. Ferner kann auf einfache Weise ein kompletter Ein- und/oder Ausbau sämtlicher Elektronikkomponenten erfolgen.

Das zumindest eine weitere Elektronikgehäuse könnte beispielsweise als eine Nachrüstbaueinheit ausgebildet und dazu vorgesehen sein, eine Funktion einer in dem zumindest einen Elektronikgehäuse angeordneten Elektronikeinheit im Nachhinein, insbesondere nach einem Verkauf und/oder einer Inbetriebnahme eines die Haushaltskältegerätevorrichtung aufweisenden Haushaltskältegeräts, zu verbessern und/oder zu erweitern. Erfindungsgemäß umfasst die Haushaltskältegerätevorrichtung jedoch das zumindest eine weitere Elektronikgehäuse, wodurch insbesondere eine funktionstüchtige Haushaltskältegerätevorrichtung erreicht werden kann, da beispielsweise empfindliche, insbesondere störungsanfällige Elektronikeinheiten separat von weiteren Elektronikeinheiten gelagert werden können.

Beispielsweise könnte das zumindest eine Anschlusselement für sich allein betrachtet dazu vorgesehen sein, in dem wenigstens einen Betriebszustand das zumindest eine weitere Elektronikgehäuse an dem zumindest einen Elektronikgehäuse zu befestigen. Vorzugsweise weist das zumindest eine Elektronikgehäuse jedoch zumindest ein weiteres Anschlusselement auf, das zu dem zumindest einen Anschlusselement beabstandet angeordnet und dazu vorgesehen ist, das zumindest eine weitere Elektronikgehäuse in dem wenigstens einen montierten Zustand wenigstens teilweise aufzunehmen. Vorzugsweise ist das zumindest eine weitere Anschlusselement über einen Anteil von mindestens 20 %, insbesondere von mindestens 40 % und vorteilhaft von mindestens 60 % einer längsten Seite eines das zumindest eine Elektronikgehäuse gerade noch umschließenden Quaders zu dem zumindest einen Anschlusselement beabstandet, insbesondere entfernt, angeordnet. Alternativ oder zusätzlich ist das zumindest eine weitere Anschlusselement insbesondere über eine Strecke von mindestens 1 cm, insbesondere von mindestens 3 cm und vorteilhaft von mindestens 5 cm zu dem zumindest einen Anschlusselement beabstandet, insbesondere entfernt, angeordnet. Insbesondere ist das zumindest eine weitere Anschlusselement über eine Strecke von maximal 95 % eines Betrags einer Diagonalen einer größten Seitenwand des das zumindest eine Elektronikgehäuse gerade noch umschließenden Quaders zu dem zumindest einen Anschlusselement beabstandet angeordnet, wobei das zumindest eine Anschlusselement und das zumindest eine weitere Anschlusselement insbesondere auf derselben Fläche und/oder Seite des zumindest einen Elektronikgehäuses angeordnet sind. Unter der Wendung, dass das zumindest eine weitere Anschlusselement dazu vorgesehen ist, das zumindest eine weitere Elektronikgehäuse in dem wenigstens einen montierten Zustand "wenigstens teilweise" aufzunehmen, soll insbesondere verstanden werden, dass das zumindest eine weitere Anschlusselement in dem wenigstens einen montierten Zustand einen Teilbereich, insbesondere ein Element wie beispielsweise einen Vorsprung, des zumindest einen weiteren Elektronikgehäuses aufnimmt. Unter der Wendung, dass das zumindest eine weitere Anschlusselement dazu vorgesehen ist, das zumindest eine weitere Elektronikgehäuse in dem wenigstens einen montierten Zustand wenigstens teilweise "aufzunehmen", soll insbesondere verstanden werden, dass das zumindest eine weitere Anschlusselement, ausgehend von einem Schwerpunkt des zumindest einen weiteren Anschlusselements in dem wenigstens einen montierten Zustand, die zumindest eine Elektronikeinheit in wenigstens einer Ebene über einen Winkelbereich von mindestens 90°, insbesondere von mindestens 180°, vorteilhaft von mindestens 294° und vorzugsweise von mindestens 300° umgibt, insbesondere umgreift, vorteilhaft umschließt. Dadurch kann insbesondere eine hohe Stabilität und/oder eine sichere Lagerung des zumindest einen weiteren Elektronikgehäuses erreicht werden.

Weiterhin wird vorgeschlagen, dass das zumindest eine weitere Elektronikgehäuse zumindest ein Kontaktelement aufweist, das dazu vorgesehen ist, in dem wenigstens einen montierten Zustand wenigstens teilweise durch das zumindest eine weitere Anschlusselement hindurchzugreifen. Unter einem "Kontaktelement" soll insbesondere ein Element verstanden werden, das dazu vorgesehen ist, in dem wenigstens einen montierten Zustand insbesondere eine Verbindung zu wenigstens einem Teil des zumindest einen Elektronikgehäuses herzustellen und vorteilhaft wenigstens einen Teil einer Gewichtskraft des zumindest einen weiteren Elektronikgehäuses an das zumindest eine Elektronikgehäuse zu übertragen. Unter der Wendung, dass das zumindest eine Kontaktelement dazu vorgesehen ist, in dem wenigstens einen montierten Zustand "wenigstens teilweise" durch das zumindest eine weitere Anschlusselement hindurchzugreifen, soll insbesondere verstanden werden, dass das zumindest eine Kontaktelement in dem wenigstens einen montierten Zustand in das zumindest eine weitere Anschlusselement eingreift und/oder dass das zumindest eine Kontaktelement in dem wenigstens einen montierten Zustand durch das zumindest eine weitere Anschlusselement hindurchgreift. Dadurch kann insbesondere eine schnelle Montage und/oder eine stabile Befestigung des zumindest einen weiteren Elektronikgehäuses an dem zumindest einen Elektronikgehäuse erreicht werden.

Es sind verschiedene, einem Fachmann als sinnvoll erscheinende Anordnungen elektrischer Leitungen denkbar. In dem wenigstens einen Betriebszustand könnte beispielsweise die zumindest eine elektrische Leitung um die beiden beieinander angeordneten Elektronikgehäuse herumgeführt sein. Erfindungsgemäß weist das zumindest eine Elektronikgehäuse jedoch zumindest ein Führungselement auf, das dazu vorgesehen ist, in dem wenigstens einen montierten Zustand zumindest eine elektrische Leitung zwischen dem zumindest einen Elektronikgehäuse und dem zumindest einen weiteren Elektronikgehäuse hindurchzuführen. Unter einem "Führungselement" wird erfindungsgemäß ein Element verstanden, das in dem wenigstens einen montierten Zustand eine Führungsbahn ausbildet, die einen Verlauf der zumindest einen elektrischen Leitung definiert, insbesondere vorgibt, und das erfindungsgemäß weitere Elektronikgehäuse zumindest eine Oberfläche aufweist, die in dem wenigstens einen montierten Zustand der zumindest einen elektrischen Leitung zugewandt ist, wobei die zumindest eine elektrische Leitung in dem wenigstens einen montierten Zustand erfindungsgemäß die zumindest eine der zumindest einen elektrischen Leitung zugewandten Oberfläche des weiteren Elektronikgehäuses wenigstens abschnittsweise berührt, insbesondere über einen Anteil von mindestens 20 %, insbesondere von mindestens 40 %, vorteilhaft von mindestens 60 % und vorzugsweise von mindestens 80 % der zumindest einen der zumindest einen elektrischen Leitung zugewandten Oberfläche. Unter der Wendung, dass ein Element dazu vorgesehen ist, in dem wenigstens einen montierten Zustand zumindest eine elektrische Leitung "zwischen" einer ersten Baueinheit und einer zweiten Baueinheit hindurchzuführen, soll insbesondere verstanden werden, dass in dem wenigstens einen montierten Zustand wenigstens eine gedachte kürzeste Linie existiert, die eine erste Oberfläche der ersten Baueinheit, welche in dem wenigstens einen montierten Zustand der zweiten Baueinheit direkt zugewandt ist, und eine zweite Oberfläche der zweiten Baueinheit, welche in dem wenigstens einen montierten Zustand der ersten Baueinheit direkt zugewandt ist, miteinander verbindet und die die zumindest eine elektrische Leitung schneidet. Unter der Wendung, dass ein Element dazu vorgesehen ist, in dem wenigstens einen montierten Zustand zumindest eine elektrische Leitung zwischen einer ersten Baueinheit und einer zweiten Baueinheit "hindurchzuführen", soll insbesondere verstanden werden, dass sich die zumindest eine elektrische Leitung in dem wenigstens einen montierten Zustand vorteilhaft über einen Anteil von mindestens 20 %, insbesondere von mindestens 40 % und vorteilhaft von mindestens 60 % einer längsten Seite einer der Oberflächen zwischen der ersten Baueinheit und der zweiten Baueinheit erstreckt und/oder dass sich die zumindest eine elektrische Leitung in dem wenigstens einen montierten Zustand insbesondere über eine Strecke von mindestens 1 cm, insbesondere von mindestens 3 cm und vorteilhaft von mindestens 5 cm zwischen der ersten Baueinheit und der zweiten Baueinheit erstreckt. Dadurch kann insbesondere eine kompakte und/oder platzsparende Bauweise erreicht werden. Ferner können vorteilhaft kurze elektrische Leitungen verwendet werden, wodurch insbesondere geringe Kosten erreicht werden können.

Zudem wird vorgeschlagen, dass das zumindest eine Elektronikgehäuse zumindest ein weiteres Führungselement aufweist, das dazu vorgesehen ist, in dem wenigstens einen montierten Zustand zumindest eine elektrische Leitung zwischen dem zumindest einen Elektronikgehäuse und einem Haushaltskältegerätegehäuse hindurchzuführen, wodurch insbesondere eine geschützte Anordnung der zumindest einen elektrischen Leitung erreicht werden kann.

Es sind verschiedene Anordnungen des zumindest einen Elektronikgehäuses denkbar. In dem wenigstens einen montierten Zustand könnte das zumindest eine Elektronikgehäuse beispielsweise auf einem Boden zumindest eines Haushaltskältegerätegehäuses aufgelegt sein und/oder in einen von dem zumindest einen Haushaltsgerätegehäuse wenigstens teilweise umschlossenen Hohlraum eingelegt sein. Vorzugsweise weist das zumindest eine Elektronikgehäuse jedoch eine Befestigungseinheit auf, die dazu vorgesehen ist, das zumindest eine Elektronikgehäuse in dem wenigstens einen montierten Zustand an zumindest einem Haushaltskältegerätegehäuse zu befestigen. Unter einer "Befestigungseinheit" soll insbesondere eine Einheit verstanden werden, die zumindest ein Befestigungselement aufweist, das dazu vorgesehen ist, in dem wenigstens einen montierten Zustand das zumindest eine Elektronikgehäuse und das zumindest eine Haushaltskältegerätegehäuse miteinander zu verbinden, und zwar insbesondere zumindest teilweise kraftschlüssig, beispielsweise mittels einer Klemmverbindung und/oder einer Schraubverbindung, und/oder wenigstens teilweise formschlüssig, beispielsweise mittels einer Schraubverbindung und/oder mittels einer Rastverbindung und/oder mittels einer Verriegelung und/oder mittels einer durch Einhängen hergestellten Verbindung, und/oder wenigstens teilweise stoffschlüssig, beispielsweise mittels einer Klebeverbindung. Dadurch kann insbesondere eine hohe Flexibilität durch eine Vielzahl möglicher Befestigungsmöglichkeiten erreicht werden.

Ferner wird vorgeschlagen, dass die Befestigungseinheit zumindest ein Grundbefestigungselement aufweist, das dazu vorgesehen ist, das zumindest eine Elektronikgehäuse in dem wenigstens einen montierten Zustand insbesondere direkt, vorteilhaft indirekt und besonders vorteilhaft über zumindest ein Grundbefestigungsmittel an einem Boden eines Haushaltskältegerätegehäuses zu befestigen. Es sind verschiedene Anordnungen des zumindest einen Elektronikgehäuses denkbar. Das zumindest eine Grundbefestigungsmittel könnte beispielsweise getrennt von dem zumindest einen Elektronikgehäuse ausgebildet sein, wobei das zumindest eine Grundbefestigungsmittel insbesondere ein Teil der Z Haushaltskältegerätevorrichtung sein könnte. Vorzugsweise weist das zumindest eine Elektronikgehäuse jedoch das zumindest eine Grundbefestigungsmittel auf, das insbesondere als ein Teil und vorteilhaft als ein Gehäuseteil des Elektronikgehäuses ausgebildet ist. Hierdurch kann insbesondere eine hohe Stabilität erreicht werden.

Alternativ oder zusätzlich zu dem zumindest einen Grundbefestigungselement wird vorgeschlagen, dass die Befestigungseinheit zumindest ein Seitbefestigungselement aufweist, das dazu vorgesehen ist, das zumindest eine Elektronikgehäuse in dem wenigstens einen montierten Zustand insbesondere direkt an einer Seitenwand eines Haushaltskältegerätegehäuses zu befestigen, wodurch insbesondere eine Vielzahl möglicher Befestigungspositionen zu einer flexiblen Befestigung denkbar sind. Darüber hinaus kann eine besonders stabile Befestigung des zumindest einen Elektronikgehäuses an dem zumindest einen Haushaltskältegerätegehäuse erreicht werden.

Es sind verschiedene Ausgestaltungen des zumindest einen Elektronikgehäuses denkbar. Das zumindest eine Elektronikgehäuse könnte beispielsweise als einstückiges Bauteil ausgebildet sein, wobei das zumindest eine Elektronikgehäuse insbesondere zumindest stoffschlüssig verbunden sein könnte, beispielsweise durch einen Schweißprozess, einen Klebeprozess, einen Anspritzprozess und/oder einen anderen Prozess. Alternativ oder zusätzlich hierzu könnte das als einstückiges Bauteil ausgebildete zumindest eine Elektronikgehäuse vorteilhaft in einem Stück geformt sein, wie beispielsweise durch eine Herstellung aus einem Guss und/oder durch eine Herstellung in einem Ein- oder Mehrkomponentenspritzverfahren und vorteilhaft aus einem einzelnen Rohling. Hierbei könnte das zumindest eine Elektronikgehäuse beispielsweise einen Innenraum zumindest teilweise umschließen, wobei insbesondere ein Einbringen und/oder entnehmen einer Elektronikeinheit weiterhin möglich sein könnte. Vorzugsweise ist das zumindest eine Elektronikgehäuse jedoch zumindest zweiteilig ausgebildet. Insbesondere weist das zumindest eine Elektronikgehäuse zumindest zwei Gehäuseteile auf, welche insbesondere in dem wenigstens einen montierten Zustand miteinander verbunden sind, und zwar vorteilhaft werkzeuglos lösbar und insbesondere werkzeuglos unlösbar. Die zumindest zwei, insbesondere zumindest drei und vorteilhaft zumindest vier Gehäuseteile sind in dem wenigstens einen montierten Zustand insbesondere zumindest teilweise kraftschlüssig, beispielsweise mittels einer Klemmverbindung und/oder einer Schraubverbindung, und/oder wenigstens teilweise formschlüssig, beispielsweise mittels einer Schraubverbindung und/oder mittels einer Rastverbindung und/oder mittels einer Verriegelung und/oder mittels einer durch Einhängen hergestellten Verbindung, und/oder wenigstens teilweise stoffschlüssig, beispielsweise mittels einer Klebeverbindung, miteinander verbunden. Beispielsweise könnten die zumindest zwei Gehäuseteile mittels eines Scharniers, insbesondere eines Filmscharniers miteinander verbunden sein. Besonders vorteilhaft sind Elemente und/oder Einheiten des zumindest einen Elektronikgehäuses, wie insbesondere das zumindest eine Kontaktelement, das zumindest eine weitere Kontaktelement, das zumindest eine Führungselement, das zumindest eine weitere Führungselement und/oder die Befestigungseinheit, einstückig mit zumindest einem der zumindest zwei Gehäuseteile des zumindest einen Elektronikgehäuses ausgebildet. Dadurch kann insbesondere eine hohe Flexibilität und/oder ein schneller Austausch bei Vorliegen eines eventuellen Defekts einer in dem zumindest einen Elektronikgehäuse befindlichen Elektronikeinheit erreicht werden.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Haushaltsgerät mit einer Haushaltsgerätevorrichtung in einer perspektivischen schematischen Frontansicht,
- Fig. 2: das Haushaltsgerät mit der Haushaltsgerätevorrichtung in einem montierten Zustand in einer perspektivischen schematischen Rückansicht, wobei der Übersichtlichkeit halber weitere Baueinheiten nicht dargestellt sind,
- Fig. 3: ein Elektronikgehäuse und ein weiteres Elektronikgehäuse der Haushaltsgerätevorrichtung in einer perspektivischen schematischen Darstellung,
- Fig. 4: das Elektronikgehäuse in einer perspektivischen schematischen Darstellung,
- Fig. 5: das Elektronikgehäuse in einer weiteren perspektivischen schematischen Darstellung,
- Fig. 6: das Elektronikgehäuse in einer weiteren perspektivischen schematischen Darstellung, in welcher das Elektronikgehäuse um 180° gedreht dargestellt ist,
- Fig. 7: das weitere Elektronikgehäuse in einer perspektivischen schematischen Darstellung,
- Fig. 8: das weitere Elektronikgehäuse in einer weiteren perspektivischen schematischen Darstellung, in welcher das weitere Elektronikgehäuse um 180° gedreht dargestellt ist,
- Fig. 9: das Elektronikgehäuse in einem weiteren montierten Zustand an einer Seitenwand eines Haushaltsgerätegehäuses in einer perspektivischen schematischen Darstellung,
- Fig. 10: das Elektronikgehäuse und einen Boden eines Haushaltsgerätegehäuses in einem ersten Zustand bei einer Montage in einer schematischen Darstellung,
- Fig. 11: das Elektronikgehäuse und einen Boden eines Haushaltsgerätegehäuses in einem zweiten Zustand bei einer Montage in einer schematischen Darstellung,
- Fig. 12: das Elektronikgehäuse und den Boden des Haushaltsgerätegehäuses in einem dritten Zustand bei einer Montage in einer schematischen Darstellung,
- Fig. 13: das Elektronikgehäuse und den Boden des Haushaltsgerätegehäuses in einem vierten Zustand bei einer Montage in einer schematischen Darstellung,
- Fig. 14: das Elektronikgehäuse und den Boden des Haushaltsgerätegehäuses in einem fünften Zustand bei einer Montage in einer schematischen Darstellung,
- Fig. 15: das Elektronikgehäuse und den Boden des Haushaltsgerätegehäuses in einem sechsten Zustand bei einer Montage in einer schematischen Darstellung,
- Fig. 16: das Elektronikgehäuse und den Boden des Haushaltsgerätegehäuses in einem siebten Zustand bei einer Montage in einer schematischen Darstellung,
- Fig. 17: einen vergrößerten Ausschnitt aus Fig. 16 in dem siebten Zustand bei einer Montage in einer schematischen Darstellung,
- Fig. 18: einen vergrößerten Ausschnitt aus Fig. 16 in einem achten Zustand bei einer Montage in einer schematischen Darstellung und
- Fig. 19: einen vergrößerten Ausschnitt aus Fig. 16 in dem neunten Zustand bei einer Montage in einer schematischen Darstellung.

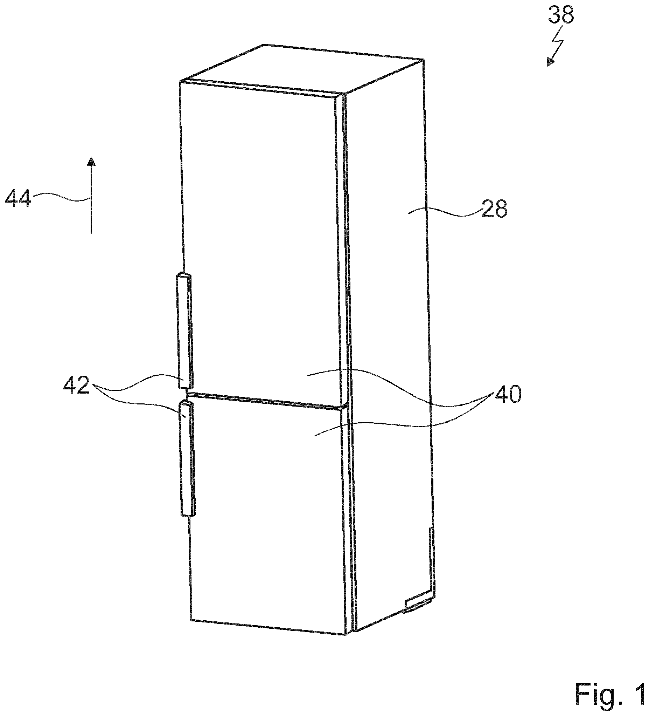

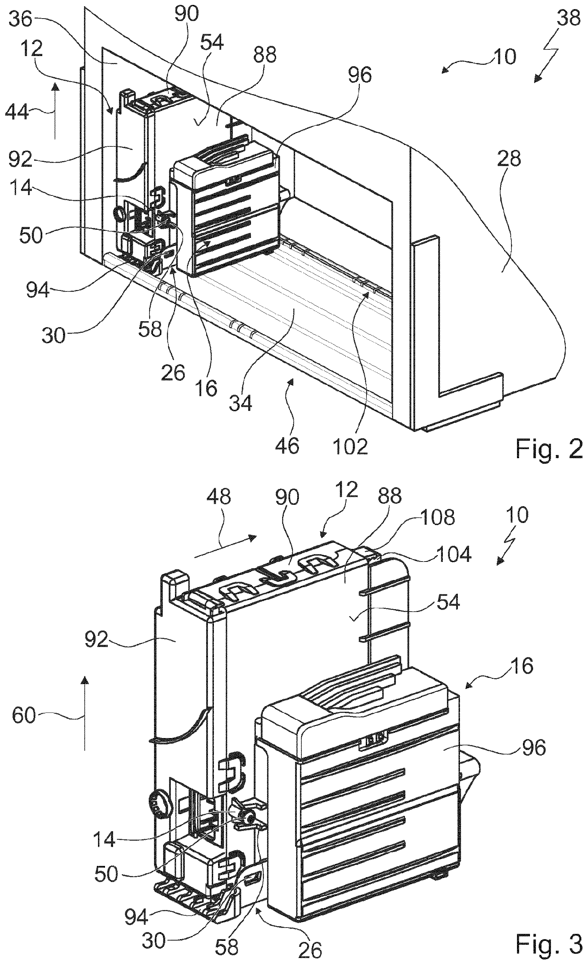

Fig. 1 und 2 zeigen ein Haushaltsgerät 38, das als Haushaltskältegerät ausgebildet ist, mit einer Haushaltsgerätevorrichtung 10, die als Haushaltskältegerätevorrichtung ausgebildet ist. Das Haushaltsgerät 38 ist als ein Standgerät ausgebildet. Alternativ ist denkbar, dass das Haushaltsgerät 38 als ein Einbaugerät ausgebildet ist. Die

Haushaltsgerätevorrichtung 10 ist dazu vorgesehen, in einem Betriebszustand Kühlgüter, wie beispielsweise Lebensmittel und/oder Getränke, zu kühlen. Die Haushaltsgerätevorrichtung 10 umfasst ein Haushaltsgerätegehäuse 28. Darüber hinaus umfasst die Haushaltsgerätevorrichtung 10 zwei Gerätetüren 40, die in dem Betriebszustand gemeinsam mit dem Haushaltsgerätegehäuse 28 ein Außengehäuse ausbilden. Die Haushaltsgerätevorrichtung 10 umfasst einen Kältekreislauf zur Kühlung von in dem Außengehäuse, insbesondere von in einem oder mehreren Kühlräumen, die von dem Außengehäuse umschlossen sind, aufbewahrten Kühlgütern. In dem Betriebszustand umschließt das Haushaltsgerätegehäuse 28 gemeinsam mit den Gerätetüren 40 zwei Kühlräume. Die Gerätetüren 40 sind in einer vertikalen Richtung 44 übereinander angeordnet. Eine erste Gerätetüren 40 verschließt in dem Betriebszustand einen der Kühlräume, in welchem in dem Betriebszustand Temperaturen unterhalb von 0°C herrschen. Eine zweite der Gerätetüren 40 verschließt in dem Betriebszustand einen der Kühlräume, in welchem in dem Betriebszustand Temperaturen in einem Bereich von 0°C bis 12°C herrschen. Im Folgenden wird lediglich eine der Gerätetüren 40 sowie ein Kühlraum beschrieben.

Im vorliegenden Ausführungsbeispiel ist die Gerätetür 40 beweglich relativ zu dem Haushaltsgerätegehäuse 28 an dem Haushaltsgerätegehäuse 28 befestigt und umschließt in dem Betriebszustand gemeinsam mit dem Haushaltsgerätegehäuse 28 den Kühlraum. In einem montierten Zustand ist die Gerätetür 40 an einer Außenwand des Haushaltsgerätegehäuses 28 befestigt. Die Gerätetür 40 ist hierbei um eine Drehachse schwenkbar relativ zu dem Haushaltsgerätegehäuse 28 gelagert. Die Gerätetür 40 weist einen Türgriff 42 auf, der dazu vorgesehen ist, von einem Bediener betätigt zu werden, um die Gerätetür 40 relativ zu dem Haushaltsgerätegehäuse 28 zu bewegen.

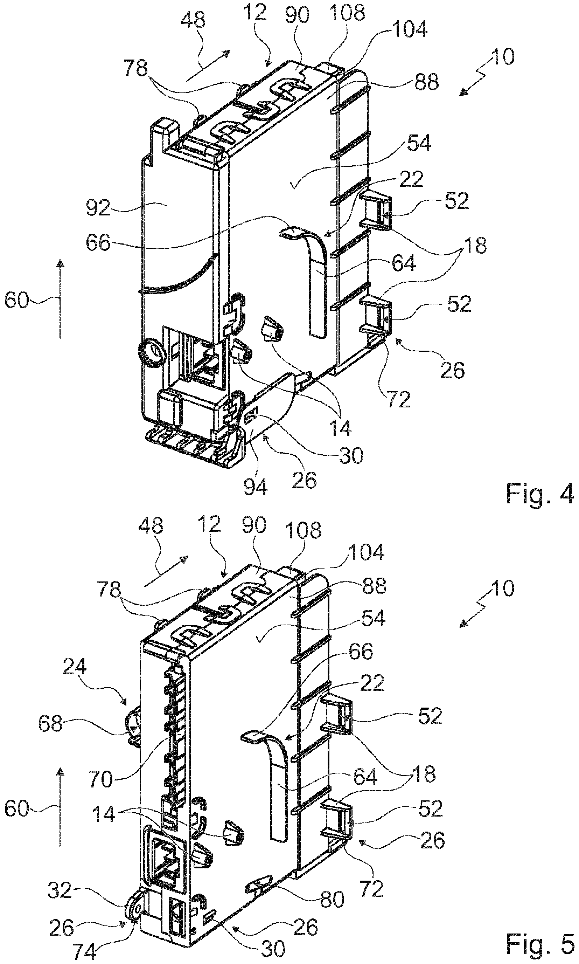

In einem bezüglich der vertikalen Richtung 44 unteren Bereich weist das Haushaltsgerätegehäuse 28 eine Ausnehmung auf, die einen Maschinenraum 46 ausbildet (vgl. Fig. 2). Der Maschinenraum 46 ist zu einer Unterbringung von für den Betrieb erforderlichen Baueinheiten, wie insbesondere Maschinen und/oder Elektronikeinheiten, vorgesehen. Diese für den Betrieb erforderlichen Baueinheiten sind der Übersichtlichkeit halber in Fig. 2 nicht dargestellt. Die Haushaltsgerätevorrichtung 10 umfasst ein Elektronikgehäuse 12 und ein weiteres Elektronikgehäuse 16, die beide in dem montierten Zustand in dem Maschinenraum 46 angeordnet sind. In dem montierten Zustand trägt das Elektronikgehäuse 12 das weitere Elektronikgehäuse 16 (vgl. Fig. 5). Das Elektronikgehäuse 12 nimmt eine Gewichtskraft des weiteren Elektronikgehäuses 16 auf, das in dem montierten Zustand an dem Elektronikgehäuse 12 befestigt ist.

Das Elektronikgehäuse 12 weist zwei Anschlusselemente 14 auf (vgl. Fig. 4). Die Anschlusselemente 14 sind bezüglich einer ersten Richtung 48 versetzt relativ zueinander angeordnet. Die erste Richtung 48 ist im Wesentlichen parallel zu einer ersten Oberfläche 54 des Elektronikgehäuses 12 ausgerichtet. Zudem ist die erste Richtung 48 in einer Einbaulage im Wesentlichen senkrecht zu einer Schwerkraftrichtung. In dem montierten Zustand und in der Einbaulage ist die erste Richtung 48 im Wesentlichen senkrecht zu der vertikalen Richtung 44 ausgerichtet.

Zusätzlich zu den Anschlusselementen 14 weist das Elektronikgehäuse 12 zwei weitere Anschlusselemente 18 auf, die zu den Anschlusselementen 14 beabstandet angeordnet sind. Die weiteren Anschlusselemente 18 sind bezüglich der ersten Richtung 48 zu den Anschlusselementen 14 beabstandet angeordnet. Die weiteren Anschlusselemente 18 sind bezüglich einer zweiten Richtung 60 versetzt relativ zueinander angeordnet. Die zweite Richtung 60 ist im Wesentlichen parallel zu der ersten Oberfläche 54 des Elektronikgehäuses 12 ausgerichtet. Zudem ist die zweite Richtung 60 in einer Einbaulage im Wesentlichen antiparallel zu einer Schwerkraftrichtung ausgerichtet. In dem montierten Zustand und in der Einbaulage ist die zweite Richtung 60 im Wesentlichen parallel zu der vertikalen Richtung 44 ausgerichtet.

Die weiteren Anschlusselemente 18 befestigen in dem montierten Zustand zwei zueinander bezüglich der zweiten Richtung 60 versetzt angeordnete Elemente, insbesondere Kontaktelemente 20, des weiteren Elektronikgehäuses 16 an dem Elektronikgehäuse 12, vorteilhaft um eine sichere Befestigung des weiteren Elektronikgehäuses 16 zu erreichen und insbesondere um ein Verkippen des weiteren Elektronikgehäuses 16 zu verhindern.

Die Anschlusselemente 14 befestigen in dem montierten Zustand ein erstes Ende des weiteren Elektronikgehäuses 16 an dem Elektronikgehäuse 12. In dem montierten Zustand befestigen die weiteren Anschlusselemente 18 ein zweites Ende des weiteren Elektronikgehäuses 16, das dem ersten Ende gegenüberliegt, an dem Elektronikgehäuse 12. Die versetzt angeordneten Anschlusselemente 14 sind dazu vorgesehen, eine Befestigung unterschiedlicher Größen an weiteren Elektronikgehäusen 16 an dem Elektronikgehäuse 12 zu ermöglichen. Somit ist jedes der Anschlusselemente 14 dazu vorgesehen, jeweils ein weiteres Elektronikgehäuse 16 an dem Elektronikgehäuse 12 zu befestigen. Hierbei weisen die weiteren Elektronikgehäuse 16 unterschiedliche Größen auf. In alternativen Ausgestaltungen des Elektronikgehäuses könnte das Elektronikgehäuse beispielsweise mehr als zwei Anschlusselemente aufweisen. Hierdurch könnte das Elektronikgehäuse in einer Vielzahl verschiedener Serien verbaut werden, in welchen jeweils ein weiteres Elektronikgehäuse einer anderen Größe Verwendung findet. Ebenfalls denkbar ist, dass das Elektronikgehäuse lediglich ein einziges Anschlusselement aufweist. Im Folgenden wird der Einfachheit halber nur eines der Anschlusselemente 14 sowie nur eines der weiteren Anschlusselemente 18 beschrieben.

Es sind verschiedene Ausgestaltungen des Anschlusselements denkbar. Beispielsweise könnte das Anschlusselement als eine Ausnehmung in dem Elektronikgehäuse ausgebildet sein, wie beispielsweise eine Ausnehmung zu einer Aufnahme eines Anschlussmittels wie insbesondere einer Schraube oder einer Niete oder eines Rastmittels oder eines Verriegelungsmittels. Ebenfalls denkbar ist, dass das Anschlusselement als ein Vorsprung ausgebildet und in dem montierten Zustand dazu vorgesehen ist, insbesondere wenigstens teilweise in eine Ausnehmung des weiteren Elektronikgehäuses hineinzugreifen und/oder vorteilhaft eine Auflage auszubilden, auf welcher in dem montierten Zustand wenigstens ein Teil des weiteren Elektronikgehäuses angeordnet ist. Im vorliegenden Ausführungsbeispiel ist das Anschlusselement 14 als ein Vorsprung ausgebildet, der eine Ausnehmung zu einer Aufnahme eines Anschlussmittels 50 aufweist. Das Anschlussmittel 50 ist als Schraube ausgebildet. Das Elektronikgehäuse 12 weist eine erste Oberfläche 54 auf, die in dem montierten Zustand dem weiteren Elektronikgehäuse 16 zugewandt ist. Die erste Oberfläche 54 ist im Wesentlichen parallel zu einer Haupterstreckungsebene des Elektronikgehäuses 12 ausgerichtet. Das Anschlusselement 14 ragt über die erste Oberfläche 54 des Elektronikgehäuses 12 hinaus. Hierbei ist eine Haupterstreckungsrichtung des Anschlusselements 14 senkrecht zu der ersten Oberfläche 54 des Elektronikgehäuses 12 ausgerichtet.

Das weitere Anschlusselement 18, das zu dem Anschlusselement 14 beabstandet angeordnet ist, nimmt das weitere Elektronikgehäuse 16 in dem montierten Zustand teilweise auf. Das weitere Anschlusselement 18 ragt aus der ersten Oberfläche 54 des Elektronikgehäuses 12 hinaus und ist als ein Vorsprung ausgebildet. Hierbei ist eine Haupterstreckungsrichtung des weiteren Anschlusselements 18 senkrecht zu der ersten Oberfläche 54 des Elektronikgehäuses 12 ausgerichtet. Um das weitere Elektronikgehäuse 16 in dem montierten Zustand teilweise aufnehmen zu können, weist das weitere Anschlusselement 18 eine erste Aufnahmeöffnung 52 auf.

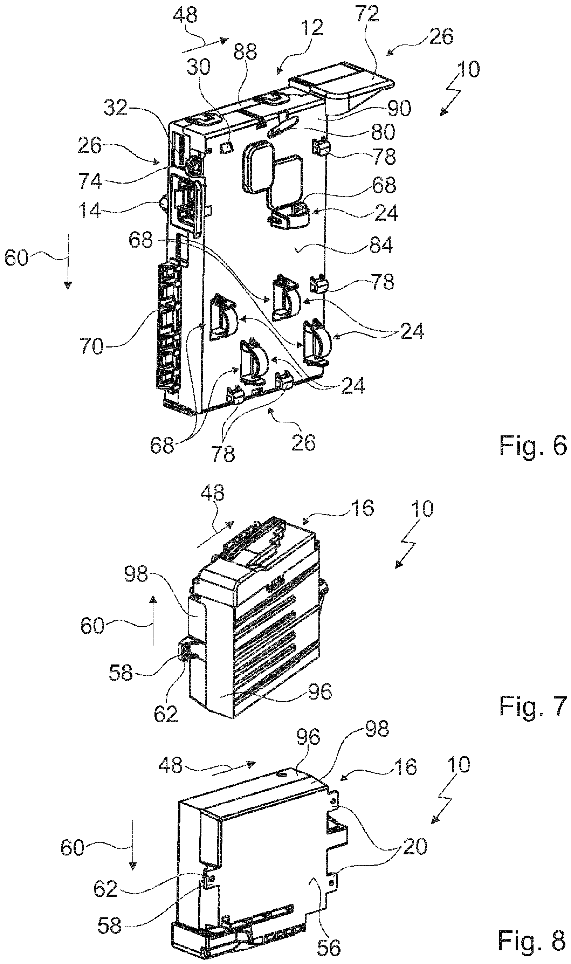

Das weitere Elektronikgehäuse 16 weist zwei Kontaktelemente 20 auf (vgl. Fig. 8), von denen im Folgenden lediglich eines beschrieben wird. Das Kontaktelement 20 greift in dem montierten Zustand teilweise durch das weitere Anschlusselement 18 hindurch. In dem montierten Zustand greift das Kontaktelement 20 durch die erste Aufnahmeöffnung 52 des weiteren Anschlusselements 18 teilweise hindurch. Das weitere Elektronikgehäuse 16 weist eine zweite Oberfläche 56 auf, die in dem montierten Zustand dem Elektronikgehäuse 12 zugewandt ist. Die zweite Oberfläche 56 ist im Wesentlichen parallel zu einer Haupterstreckungsebene des weiteren Elektronikgehäuses 16 ausgerichtet. Das Kontaktelement 20 ist in einer durch die zweite Oberfläche 56 aufgespannten Ebene angeordnet. Hierbei ragt das Kontaktelement 20 über eine äußere Begrenzung eines Grundkörpers des weiteren Elektronikgehäuses 16 hinaus. Das Kontaktelement 20 ist als ein Überstand ausgebildet.

Zusätzlich zu dem Kontaktelement 20 weist das weitere Elektronikgehäuse 16 ein weiteres Kontaktelement 58 auf, das zu dem weiteren Kontaktelement 20 beabstandet angeordnet ist. Das weitere Kontaktelement 58 ist zu dem Kontaktelement 20 bezüglich der ersten Richtung 48 beabstandet angeordnet. Hierbei sind das Kontaktelement 20 und das weitere Kontaktelement 58 auf zwei einander bezüglich der ersten Richtung 48 gegenüberliegenden Seiten des Grundkörpers des weiteren Elektronikgehäuses 16 angeordnet. Das weitere Kontaktelement 58 ist als ein Überstand ausgebildet. Das weitere Kontaktelement 58 ist in der durch die zweite Oberfläche 56 aufgespannten Ebene angeordnet. Hierbei ragt das weitere Kontaktelement 58 über eine äußere Begrenzung des Grundkörpers des weiteren Elektronikgehäuses 16 hinaus.

Das weitere Kontaktelement 58 weist eine zweite Aufnahmeöffnung 62 auf, durch welche in dem montierten Zustand ein Anschlussmittel 50 zur Befestigung des weiteren Elektronikgehäuses 16 an dem Elektronikgehäuse 12 teilweise hindurchgreift. Ein Durchmesser der zweiten Aufnahmeöffnung 62 ist kleiner als ein Durchmesser eines Kopfs eines Anschlussmittels 50, wodurch in dem montierten Zustand somit eine sichere Befestigung des weiteren Elektronikgehäuses 16 an dem Elektronikgehäuse 12 möglich ist.

In dem montierten Zustand sind die erste Oberfläche 54 des Elektronikgehäuses 12 und die zweite Oberfläche 56 des weiteren Elektronikgehäuses 16 einander zugewandt. Ein Abstand zwischen der ersten Oberfläche 54 des Elektronikgehäuses 12 und der zweiten Oberfläche 56 des weiteren Elektronikgehäuses 16 ist durch eine in der Haupterstreckungsrichtung des Anschlusselements 14 ausgerichtete Höhe des Anschlusselements 14 sowie durch einen Abstand der ersten Aufnahmeöffnung 52 von der ersten Oberfläche 54 definiert. Der Abstand zwischen der ersten Oberfläche 54 des Elektronikgehäuses 12 und der zweiten Oberfläche 56 des weiteren Elektronikgehäuses 16 beträgt maximal 2 cm, insbesondere maximal 1 cm und vorteilhaft maximal 0,5 cm.

Es sind verschiedene Ausgestaltungen des weiteren Elektronikgehäuses denkbar. Beispielsweise könnte das weitere Elektronikgehäuse als ein zu einer Seite hin offener Quader ausgebildet sein, wobei insbesondere auf die dem Elektronikgehäuse in dem montierten Zustand zugewandte zweite Oberfläche verzichtet werden könnte. Insbesondere könnte hierbei das weitere Elektronikgehäuse im Wesentlichen plan an dem Elektronikgehäuse anliegen, wobei die erste Oberfläche des Elektronikgehäuses und eine gedachte zweite Oberfläche des weiteren Elektronikgehäuses insbesondere einen Abstand von maximal 2 mm, insbesondere maximal 1 mm und vorteilhaft maximal 0,5 mm aufweisen könnten.

Das weitere Elektronikgehäuse könnte insbesondere als einstückiges Bauteil ausgebildet sein. Vorzugsweise ist das weitere Elektronikgehäuse 16 jedoch zweiteilig ausgebildet (vgl. Fig. 7 und 8). Das weitere Elektronikgehäuse 16 weist ein erstes Gehäusebauteil 96 und ein zweites Gehäusebauteil 98 auf. Das erste Gehäusebauteil 96 und das zweite Gehäusebauteil 98 sind in dem montierten Zustand aneinander befestigt. In dem Zustand, in welchem das erste Gehäusebauteil 96 und das zweite Gehäusebauteil 98 aneinander befestigt sind, bilden das erste Gehäusebauteil 96 und das zweite Gehäusebauteil 98 einen weiteren Grundkörper des weiteren Elektronikgehäuses 16 aus. Das erste Gehäusebauteil 96 ist als ein zu einer Seite hin offener Quader ausgebildet. In dem montierten Zustand ist das zweite Gehäusebauteil 98 dem Elektronikgehäuse 12 zugewandt. Das zweite Gehäusebauteil 98 bildet die zweite Oberfläche 56 aus. Das weitere Elektronikgehäuse 16 weist einen Kunststoff auf. Hierbei weist jedes der Gehäusebauteile 96, 98 einen Kunststoff auf. Das weitere Elektronikgehäuse 16 ist als Kunststoffspritzbauteil ausgebildet.

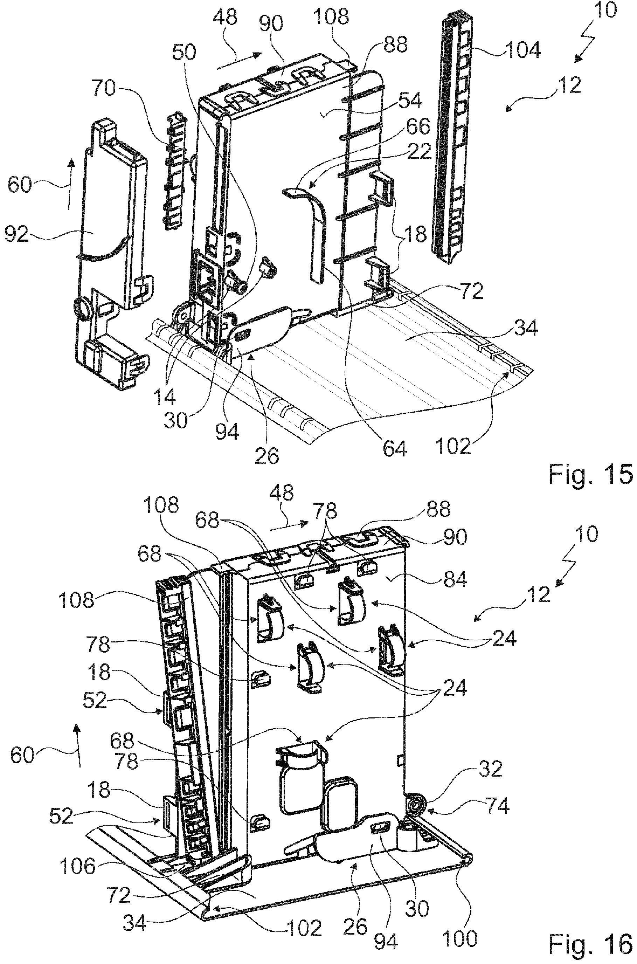

Zwischen der ersten Oberfläche 54 und der zweiten Oberfläche 56 ist in dem montierten Zustand ein Zwischenraum, in welchem in einem Betriebszustand eine elektrische Leitung (nicht dargestellt) angeordnet ist. Das Elektronikgehäuse 12 und das weitere Elektronikgehäuse 16 sind in dem montierten Zustand elektrisch miteinander verbunden, und zwar insbesondere durch die elektrische Leistung, die in dem montierten Zustand zwischen der ersten Oberfläche 54 und der zweiten Oberfläche 56 verläuft. Eine Beschreibung einer elektrischen Verbindungsmöglichkeit erfolgt später, und zwar insbesondere im Hinblick auf Fig. 15 bis 19.

Das Elektronikgehäuse 12 weist ein Führungselement 22 auf, das in dem montierten Zustand die elektrische Leitung zwischen dem Elektronikgehäuse 12 und dem weiteren Elektronikgehäuse 16 hindurchführt (vgl. Fig. 4 und 5). Das Führungselement 22 ist an der ersten Oberfläche 54 angeordnet. Eine Höhe des Führungselements 22 ist im Wesentlichen senkrecht zu der ersten Oberfläche 54 ausgerichtet. Das Führungselement 22 weist zwei Führungsabschnitte 64, 66 auf, die ineinander übergehen. Ein erster Führungsabschnitt 64 der Führungsabschnitte 64, 66 weist eine Haupterstreckungsrichtung auf, die im Wesentlichen parallel zu der zweiten Richtung 60 ausgerichtet ist. Ein zweiter Führungsabschnitt 66 der Führungsabschnitte 64, 66 weist eine gebogene Form auf. Hierbei nimmt der zweite Führungsabschnitt 64 die Form eines Kreisausschnitts an, der sich über einen Winkelbereich von im Wesentlichen 90° erstreckt. Der zweite Führungsabschnitt 66 ist entgegen der ersten Richtung 48 gebogen.

Zusätzlich zu dem Führungselement 22 weist das Elektronikgehäuse 12 fünf weitere Führungselemente 24 auf (vgl. Fig. 6). Im Folgenden wird bezüglich gleicher Ausgestaltungen der weiteren Führungselemente 24 lediglich eines der weiteren Führungselemente 24 beschrieben. In dem montierten Zustand führt das weitere Führungselement 24 eine elektrische Leitung (nicht dargestellt) zwischen dem Elektronikgehäuse 12 und dem Haushaltsgerätegehäuse 28 hindurch. Das weitere Führungselement 24 und das Führungselement 22 sind an einander gegenüberliegenden Seiten des Elektronikgehäuses 12 angeordnet. Hierbei ist das weitere Führungselement 24 an einer weiteren ersten Oberfläche 84 des Elektronikgehäuses 12 angeordnet. Die weitere erste Oberfläche 84 ist im Wesentlichen parallel zu der ersten Oberfläche 54 ausgerichtet. Zudem bilden die weitere erste Oberfläche 84 und die erste Oberfläche 54 einander gegenüberliegende Flächen des Elektronikgehäuses 12 aus.

Das weitere Führungselement 24 weist eine Führungsöffnung 68 auf, durch welche in dem montierten Zustand die elektrische Leitung hindurchgeführt ist. Es sind verschiedene Ausgestaltungen des weiteren Führungselements denkbar. Beispielsweise könnte das weitere Führungselement im Wesentlichen starr ausgebildet sein, wobei insbesondere ein Durchmesser der Führungsöffnung im Wesentlichen konstant sein könnte. Alternativ könnte das weitere Führungselement einen weiteren Führungsabschnitt aufweisen, der im Wesentlichen elastisch ausgebildet ist und vorteilhaft vorgespannt ist, um insbesondere eine Beweglichkeit der elektrischen Leitung in dem montierten Zustand zu reduzieren und/oder um vorteilhaft elektrische Leitungen unterschiedlicher Größen zwischen dem Elektronikgehäuse und dem Haushaltsgerätegehäuse hindurchführen zu können.

Darüber hinaus sind verschiedene Ausrichtungen der Führungsöffnung denkbar, wie insbesondere in Fig. 6 dargestellt ist. Eine von einer insbesondere äußeren Begrenzung der Führungsöffnung aufgespannte Ebene könnte insbesondere im Wesentlichen senkrecht zu der zweiten Richtung ausgerichtet sein, um vorteilhaft die elektrische Leitung im Wesentlichen parallel zu der zweiten Richtung zwischen dem Elektronikgehäuse und dem Haushaltsgerätegehäuse hindurchführen zu können. In Fig. 6 weist eines der weiteren Führungselemente eine derartige Ausrichtung auf. Alternativ könnte eine von einer insbesondere äußeren Begrenzung der Führungsöffnung aufgespannte Ebene insbesondere im Wesentlichen senkrecht zu der ersten Richtung ausgerichtet sein, um vorteilhaft die elektrische Leitung im Wesentlichen parallel zu der ersten Richtung zwischen dem Elektronikgehäuse und dem Haushaltsgerätegehäuse hindurchführen zu können. In Fig. 6 weisen insgesamt vier der weiteren Führungselemente eine derartige Ausrichtung auf. Weiterhin ist denkbar, dass zumindest zwei weitere Führungselemente vorgesehen sind, wobei ein erstes der weiteren Führungselemente dazu vorgesehen ist, die weitere Leitung im Wesentlichen parallel zu der zweiten Richtung zwischen dem Elektronikgehäuse und dem Haushaltsgerätegehäuse hindurchzuführen, und wobei ein zweites der weiteren Führungselemente dazu vorgesehen ist, die elektrische Leitung im Wesentlichen parallel zu der ersten Richtung zwischen dem Elektronikgehäuse und dem Haushaltsgerätegehäuse hindurchzuführen.

Das Elektronikgehäuse 12 ist mehrteilig ausgebildet. Im vorliegenden Ausführungsbeispiel ist das Elektronikgehäuse 12 vierteilig ausgebildet (vgl. Fig. 4 bis 6). Das Elektronikgehäuse 12 weist ein erstes Gehäuseteil 88 und ein zweites Gehäuseteil 90 auf. Das erste Gehäuseteil 88 und das zweite Gehäuseteil 90 sind in einem befestigten Zustand aneinander befestigt. In dem befestigten Zustand, in welchem das erste Gehäuseteil 88 und das zweite Gehäuseteil 90 aneinander befestigt sind, bilden das erste Gehäuseteil 88 und das zweite Gehäuseteil 90 den Grundkörper des Elektronikgehäuses 12 aus. In dem befestigten Zustand sind das erste Gehäuseteil 88 und das zweite Gehäuseteil 90 werkzeuglos lösbar aneinander befestigt. Hierbei sind das erste Gehäuseteil 88 und das zweite Gehäuseteil 90 mittels einer Rastverbindung aneinander befestigt. Alternativ könnten das erste Gehäuseteil und das zweite Gehäuseteil mittels einer Steckverbindung und/oder mittels einer durch eine Verriegelung hergestellten Verbindung miteinander verbunden sein. Zudem ist denkbar, dass das erste Gehäuseteil und das zweite Gehäuseteil werkzeuglos unlösbar miteinander verbunden sind, beispielsweise durch eine Schraubverbindung und/oder eine Nietverbindung.

Das Elektronikgehäuse 12 weist eine Elektronikschnittstelle 70 auf (vgl. Fig. 5 und 6), die zu einem Anschluss von wenigstens einer elektrischen Leitung vorgesehen ist. Beispielsweise könnte die das Elektronikgehäuse und das weitere Elektronikgehäuse verbindende elektrische Leitung an der Elektronikschnittstelle angeschlossen sein. Alternativ oder zusätzlich könnte eine elektrische Leitung, welche das Elektronikgehäuse und eine sich in dem Haushaltsgerätegehäuse befindliche Elektronik miteinander verbindet, an der Elektronikschnittstelle angeschlossen sein. Das Elektronikgehäuse 12 weist eine Gehäuseabdeckung 92 auf (vgl. Fig. 4), die insbesondere ein weiteres Gehäuseteil des Elektronikgehäuses 12 ausbildet. Die Gehäuseabdeckung 92 bedeckt in dem montierten Zustand die Elektronikschnittstelle 70. In dem montierten Zustand ist die Gehäuseabdeckung 92 mit dem Grundkörper des Elektronikgehäuses 12 verbunden. Hierbei ist die Gehäuseabdeckung 92 mit dem Grundkörper des Elektronikgehäuses 12 verrastet. Die Gehäuseabdeckung 92 verhindert in dem montierten Zustand einen Kontakt beispielsweise eines Bedieners mit der Elektronikschnittstelle 70.

Das Elektronikgehäuse 12 weist ein Grundbefestigungsmittel 94 auf (vgl. Fig. 4), das insbesondere ein weiteres Gehäuseteil des Elektronikgehäuses 12 ausbildet. In dem montierten Zustand stellt das Grundbefestigungsmittel 94 eine Verbindung zwischen dem Elektronikgehäuse 12 und einem Boden 34 des Haushaltsgerätegehäuses 28 her. Es sind verschiedene Ausgestaltungen des Bodens denkbar. Beispielsweise könnte der Boden eine Platte aufweisen. Im vorliegenden Ausführungsbeispiel weist der Boden 34 jedoch eine Tragschiene auf.

Das Elektronikgehäuse 12 weist einen Kunststoff auf. Hierbei ist das Elektronikgehäuse 12 als Kunststoffspritzbauteil ausgebildet. Das erste Gehäuseteil 88, das zweite Gehäuseteil 90, die Gehäuseabdeckung 92 und das Grundbefestigungsmittel 94 weisen jeweils einen Kunststoff auf. Hierbei könnten das erste Gehäuseteil 88, das zweite Gehäuseteil 90, die Gehäuseabdeckung 92 und das Grundbefestigungsmittel 94 insbesondere unterschiedliche Kunststoffe aufweist. Vorteilhaft weisen das erste Gehäuseteil 88, das zweite Gehäuseteil 90, die Gehäuseabdeckung 92 und das Grundbefestigungsmittel 94 jedoch denselben Kunststoff auf.

Das Elektronikgehäuse 12 weist eine Befestigungseinheit 26 auf, die das Elektronikgehäuse 12 in dem montierten Zustand an dem Haushaltsgerätegehäuse 28 befestigt. Es sind verschiedene Ausgestaltungen der Befestigungseinheit denkbar.

Beispielsweise könnte die Befestigungseinheit dazu vorgesehen sein, das Elektronikgehäuse an lediglich einer Position des Haushaltsgerätegehäuses zu befestigen, wobei insbesondere zumindest eine Kontaktstelle und vorteilhaft zumindest zwei Kontaktstellen zwischen dem Elektronikgehäuse und dem Haushaltsgerätegehäuse vorgesehen sein könnten. Im vorliegenden Ausführungsbeispiel ist die Befestigungseinheit 26 dazu vorgesehen, das Elektronikgehäuse 12 an verschiedenen Positionen des Haushaltsgerätegehäuses 28 zu befestigen. Hierbei ist die Befestigungseinheit 26 dazu vorgesehen, das Elektronikgehäuse 12 an zwei verschiedenen Positionen des Haushaltsgerätegehäuses 28 zu befestigen. Alternativ könnte die Befestigungseinheit dazu vorgesehen sein, das Elektronikgehäuse an mehr als zwei Positionen des Haushaltsgerätegehäuses zu befestigen, wobei pro Position insbesondere zumindest eine Kontaktstelle und vorteilhaft zumindest zwei Kontaktstellen zwischen dem Elektronikgehäuse und dem Haushaltsgerätegehäuse vorgesehen sein könnten.

Die Befestigungseinheit 26 weist zwei Grundbefestigungselemente 30 auf. Die Grundbefestigungselemente 30 sind an einander gegenüberliegenden Seiten des Elektronikgehäuses 12 angeordnet. Im Folgenden wird lediglich eines der Grundbefestigungselemente 30 beschrieben. Die Befestigungseinheit 26 weist eine Grundbefestigungslagerung 80 auf. Die Grundbefestigungslagerung 80 ist als eine Ausnehmung ausgebildet und erstreckt sich in dem montierten Zustand durch das Elektronikgehäuse 12 hindurch. Alternativ könnte die Grundbefestigungslagerung insbesondere zumindest einen Vorsprung und vorteilhaft zumindest zwei Vorsprünge aufweisen, welche in dem montierten Zustand insbesondere zumindest teilweise in Ausnehmungen des Grundbefestigungsmittels eingreifen könnten. Das Grundbefestigungselement 30 und die Grundbefestigungslagerung 80 befestigen das Elektronikgehäuse 12 in dem montierten Zustand an dem Boden 34 des Haushaltsgerätegehäuses 28 (vgl. Fig. 5), und zwar insbesondere indirekt über das Grundbefestigungsmittel 94.

In dem montierten Zustand ist das Grundbefestigungsmittel 94 insbesondere werkzeuglos unlösbar an der Grundbefestigungslagerung 80 befestigt. Das Grundbefestigungsmittel 94 weist einen Vorsprung (nicht dargestellt) auf, der in dem montierten Zustand teilweise in die Grundbefestigungslagerung 80 eingreift. Die Grundbefestigungslagerung 80 bildet eine Lagerachse aus, um welche das Grundbefestigungsmittel 94 schwenkbar an dem Grundkörper des Elektronikgehäuses 12 gelagert ist. Alternativ zu einer Ausgestaltung des Grundbefestigungsmittels mit Vorsprüngen ist denkbar, dass das Grundbefestigungsmittel mittels eines Bolzens, der sich insbesondere durch die Grundbefestigungslagerung erstreckt, an dem Grundkörper des Elektronikgehäuses befestigt ist.

Das an der Grundbefestigungslagerung 80 gelagerte Grundbefestigungsmittel 94 ist in dem montierten Zustand mit dem Grundbefestigungselement 30 und dem Boden 34 verbunden. Es sind verschiedene Befestigungsmöglichkeiten des Grundbefestigungsmittels an dem Grundbefestigungselement denkbar. Beispielsweise könnte das Grundbefestigungselement in dem montierten Zustand das Grundbefestigungsmittel werkzeuglos unlösbar an dem Grundkörper des Elektronikgehäuses befestigen, wie insbesondere durch eine Schraubverbindung und/oder eine Nietverbindung und/oder durch eine Klebeverbindung.

Vorzugsweise befestigt das Grundbefestigungselement 30 das Grundbefestigungsmittel 94 jedoch werkzeuglos lösbar an dem Grundkörper des Elektronikgehäuses 12. Hierbei verrastet das Grundbefestigungselement 30 das Grundbefestigungsmittel 94 an dem Grundkörper des Elektronikgehäuses 12. Alternativ könnte das Grundbefestigungselement das Grundbefestigungsmittel an dem Grundkörper des Elektronikgehäuses verriegeln. Alternativ sind weitere, einem Fachmann als sinnvoll erscheinende Befestigungen denkbar. Das Grundbefestigungselement 30 ist als ein Vorsprung ausgebildet. Das Grundbefestigungsmittel 94 weist eine Ausnehmung auf. In dem montierten Zustand greift das Grundbefestigungselement 30 durch das Grundbefestigungsmittel 94 teilweise hindurch. Hierbei greift das Grundbefestigungselement 30 in die Ausnehmung des Grundbefestigungsmittels 94. In dem montierten Zustand greift das Grundbefestigungsmittel 94 in eine Nut 100 des Bodens 34 ein.

Die Befestigungseinheit 26 weist ein weiteres Grundbefestigungselement 72 auf, das in dem montierten Zustand das Elektronikgehäuse 12 an dem Boden 34 des Haushaltsgerätegehäuses 28 befestigt (vgl. Fig. 4, 5 und 6). Das weitere Grundbefestigungselement 72 ist zu dem Grundbefestigungselement 30 beabstandet angeordnet. Hierbei sind das weitere Grundbefestigungselement 72 und das Grundbefestigungselement 30 an einander gegenüberliegenden Enden des Elektronikgehäuses 12 angeordnet. Das weitere Grundbefestigungselement 72 ist als ein Überstand ausgebildet. In dem montierten Zustand greift das weitere Grundbefestigungselement 72 in eine weitere Nut 102 des Bodens 34 ein. Die Nut 100 des Bodens 34 und die weitere Nut 102 des Bodens 34 sind an einander gegenüberliegenden Enden des Bodens 34 angeordnet. Die Befestigungseinheit 26 spannt das Elektronikgehäuse 12 in dem montierten Zustand zwischen den zwei einander gegenüberliegenden Enden des Bodens 34 ein, und zwar insbesondere gemeinsam mit dem Grundbefestigungsmittel 94 (vgl. Fig. 2 und 10 bis 12).

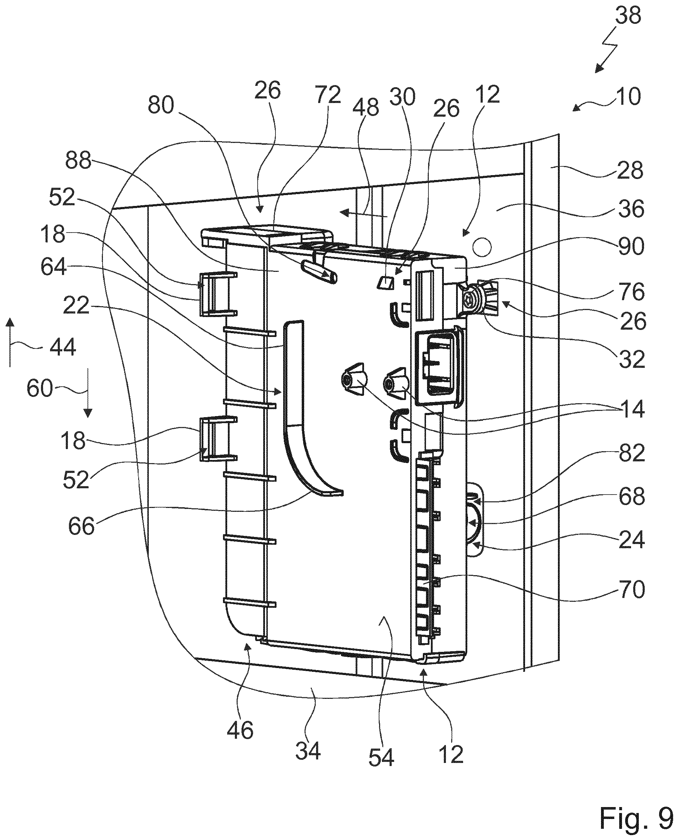

Zusätzlich zu dem Grundbefestigungselement 30 weist die Befestigungseinheit 26 ein Seitbefestigungselement 32 auf, das das Elektronikgehäuse 12 in dem montierten Zustand an einer Seitenwand 36 des Haushaltsgerätegehäuses 28 befestigt (vgl. Fig. 6 und 9). In einer alternativen Ausgestaltung der Befestigungseinheit könnte die Befestigungseinheit lediglich ein Befestigungselement, also insbesondere entweder das Grundbefestigungselement oder das Seitbefestigungselement, aufweisen. Das Seitbefestigungselement 32 ist als ein Überstand ausgebildet. Das Seitbefestigungselement 32 weist eine Seitbefestigungsaufnahme 74 auf, die in dem montierten Zustand ein Seitbefestigungsmittel 76 aufnimmt. Das Seitbefestigungsmittel 76 ist als eine Schraube ausgebildet. In dem montierten Zustand greift das Seitbefestigungsmittel 76 durch die Seitbefestigungsaufnahme 74 hindurch und in die Seitenwand 36 ein. Hierdurch ist das Elektronikgehäuse 12 an der Seitenwand 36 befestigt.

Die Befestigungseinheit 26 weist zumindest ein weiteres Seitbefestigungselement 78 auf. Im vorliegenden Ausführungsbeispiel weist die Befestigungseinheit 26 vier weitere Seitbefestigungselemente 78 auf, von welchen im Folgenden lediglich eines beschrieben wird (vgl. Fig. 6). Das weitere Seitbefestigungselement 78 ist an der weiteren ersten Oberfläche 84 des Elektronikgehäuses 12 angeordnet. Das weitere Seitbefestigungselement 78 steht über die weitere erste Oberfläche 84 des Elektronikgehäuses 12 hinaus. In dem montierten Zustand greift das weitere Seitbefestigungselement 78 durch die Seitenwand 36 teilweise hindurch. Das weitere Seitbefestigungselement 78 ist als ein Haken ausgebildet. Die Seitenwand 36 weist für das Seitbefestigungselement 32 eine Öffnung (nicht dargestellt) auf. In dem montierten Zustand greift das weitere Seitbefestigungselement 78 durch die Öffnung der Seitenwand 36 teilweise hindurch.

Die Seitenwand 36 weist eine weitere Öffnung 82 auf (vgl. Fig. 9). In dem montierten Zustand greift das weitere Führungselement 24 teilweise durch die weitere Öffnung 82 hindurch. Hierdurch kann das Elektronikgehäuse 12 platzsparend an der Seitenwand 36 angeordnet werden, und zwar insbesondere in einem geringen Abstand zwischen dem Elektronikgehäuse 12 und dem Haushaltsgerätegehäuse 28.

In einem Verfahren zur Montage der Haushaltsgerätevorrichtung 10 wird zunächst das Elektronikgehäuse 12 an dem Haushaltsgerätegehäuse 28 befestigt. In einem weiteren Verfahrensschritt wird das weitere Elektronikgehäuse 16 an dem Elektronikgehäuse 12 befestigt. Alternativ könnte in einem ersten Verfahrensschritt das weitere Elektronikgehäuse an dem Elektronikgehäuse befestigt werden und anschließend in einem weiteren Verfahrensschritt könnte das Elektronikgehäuse an dem Haushaltsgerätegehäuse befestigt werden.

Der Boden 34 des Haushaltsgerätegehäuses 28 weist die Nut 100 und die weitere Nut 102 auf. Die Nuten 100, 102 des Bodens 34 sind an einander gegenüberliegenden Enden des Bodens 34 angeordnet. Jede Nut 100, 102 weist eine im Wesentlichen u-förmige Gestalt auf. Jede u-förmige Gestalt der Nuten 100, 102 weist eine Öffnung auf. Die Öffnungen der u-förmigen Gestalten der Nuten 100, 102 sind einander zugewandt. Alternativ zu der u-förmigen Gestalt könnten die Nuten eine im Wesentlichen c-förmige Gestalt aufweisen. Denkbar sind weitere, sinnvoll erscheinende Ausgestaltungen der Nuten.

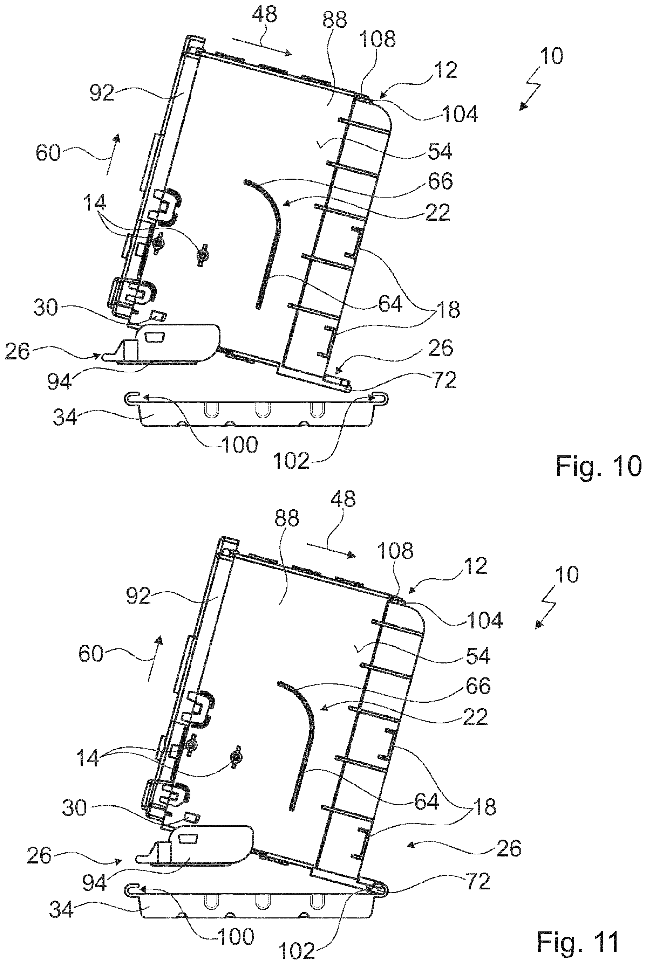

Fig. 10 bis 14 zeigen einzelne Verfahrensschritte bei einer Befestigung des Elektronikgehäuses 12 an dem Boden 34 des Haushaltsgerätegehäuses 28. In einem ersten Verfahrensschritt wird das Grundbefestigungsmittel 94 mittels der Grundbefestigungslagerung 80 an dem Grundkörper des Elektronikgehäuses 12 befestigt. Das schwenkbar mittels der Grundbefestigungslagerung 80 an dem Grundkörper des Elektronikgehäuses 12 befestigte Grundbefestigungsmittel 94 wird schräg relativ zu dem Grundkörper des Elektronikgehäuses 12 ausgerichtet. Somit wird zunächst auf eine Befestigung des Grundbefestigungsmittels 94 an dem Grundbefestigungselement 30 verzichtet.

In einem weiteren Verfahrensschritt wird das weitere Grundbefestigungselement 72 in die weitere Nut 102 des Bodens 34 eingeführt (vgl. Fig. 10). Hierbei wird das Elektronikgehäuse 12 in einer in den Maschinenraum 46 hineinweisenden Richtung auf die weitere Nut 102 zubewegt. Diese Bewegung in Richtung der weiteren Nut 102 wird so lange fortgeführt, bis das weitere Grundbefestigungselement 72 in der weiteren Nut 102 zu liegen kommt (vgl. Fig. 11).

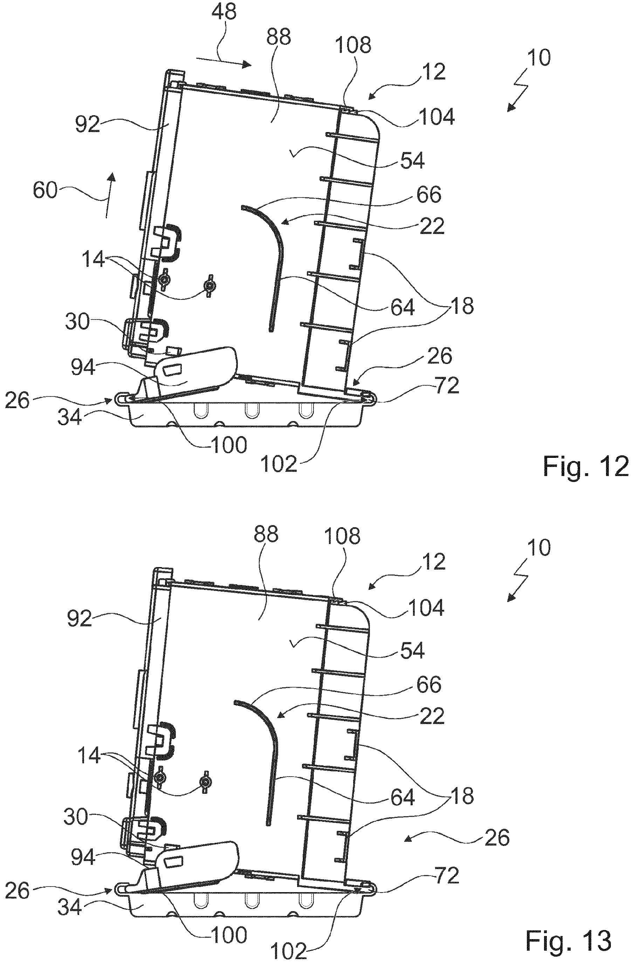

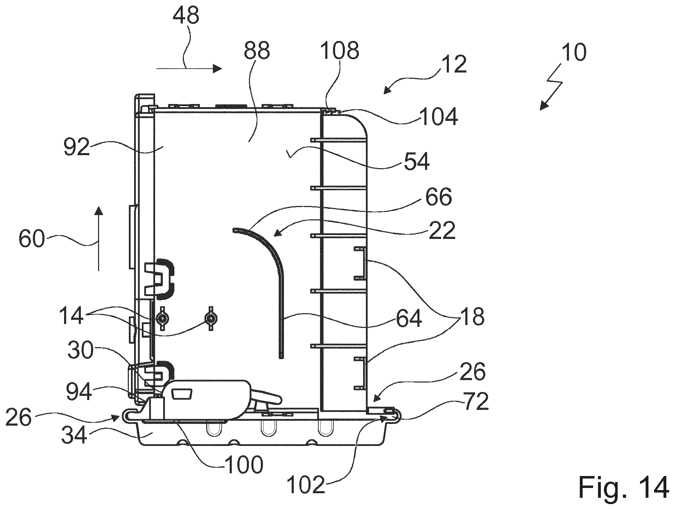

Anschließend wird das schwenkbar an dem Grundkörper des Elektronikgehäuses 12 befestigte Grundbefestigungsmittel 94 in die Nut 100 des Bodens 34 eingeführt (vgl. Fig. 12). Nachdem das Grundbefestigungsmittel 94 in die Nut 100 des Bodens 34 eingeführt ist, wird eine in Richtung des Bodens 34 gerichtete Kraft auf den Grundkörper des Elektronikgehäuses 12 ausgeübt. Hierdurch werden das weitere Grundbefestigungselement 72 und das Grundbefestigungsmittel 94 weiter in die jeweilige Nut 100, 102 des Bodens 34 gedrückt. Zudem wird der Grundkörper des Elektronikgehäuses 12 in Richtung des Bodens 34 bewegt. Hierdurch nimmt ein Abstand zwischen dem Grundkörper des Elektronikgehäuses 12 und einem vorderen Bereich des Grundbefestigungsmittels 94 ab (vgl. Fig. 13). Diese Bewegung wird so lange fortgeführt, bis das Grundbefestigungselement 30 und das Grundbefestigungsmittel 94 miteinander verrasten (vgl. Fig. 14).

In dem an dem Boden 34 befestigten Zustand des Grundkörpers des Elektronikgehäuses 12 werden die Gehäuseabdeckung 92, die Elektronikschnittstelle 70 sowie eine weitere Elektronikschnittstelle 104 des Elektronikgehäuses 12 an dem Grundkörper des Elektronikgehäuses 12 befestigt (vgl. Fig. 15). Zunächst wird die Elektronikschnittstelle 70 an einer in dem montierten Zustand einem Bediener zuweisenden Seite des Elektronikgehäuses 12 an dem Grundkörper des Elektronikgehäuses 12 befestigt. Die Elektronikschnittstelle 70 wird teilweise kraftschlüssig und/oder teilweise formschlüssig, insbesondere mittels einer Steckverbindung, an dem Grundkörper des Elektronikgehäuses 12 befestigt. Alternativ oder zusätzlich könnte die Elektronikschnittstelle stoffschlüssig an dem Grundkörper des Elektronikgehäuses befestigt werden. Nach Befestigung der Elektronikschnittstelle 70 wird die Gehäuseabdeckung 92 an dem Grundkörper des Elektronikgehäuses 12 befestigt. Durch diese Befestigung ist die Elektronikschnittstelle 70 in dem montierten Zustand von der Gehäuseabdeckung 92 verdeckt und insbesondere vor einem ungewollten Kontakt geschützt.

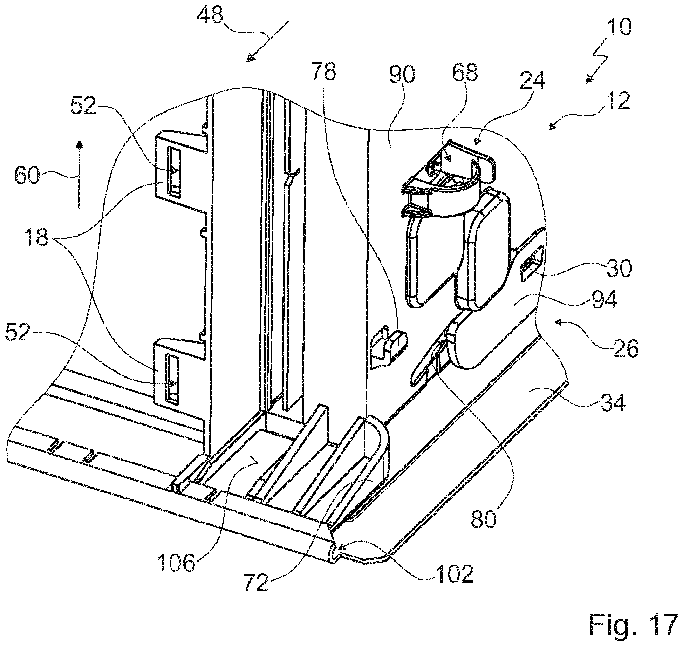

Das Elektronikgehäuse 12 weist die weitere Elektronikschnittstelle 104 auf. Die weitere Elektronikschnittstelle 104 wird an einem der Elektronikschnittstelle 72 gegenüberliegenden Ende des Elektronikgehäuses 12 an dem Grundkörper des Elektronikgehäuses 12 befestigt. Hierbei wird die weitere Elektronikschnittstelle 104 an einem Ende des Grundkörpers des Elektronikgehäuses 12 befestigt, das in dem montierten Zustand in den Maschinenraum 46 hineinweist. Die weitere Elektronikschnittstelle 104 wird an dem Grundkörper des Elektronikgehäuses 12 verrastet. Das weitere Grundbefestigungselement 72 weist eine Schnittstellenlagerung 106 auf (vgl. Fig. 17). Die Schnittstellenlagerung 106 weist eine Oberfläche auf, die sich im Wesentlichen in einer Ebene erstreckt. Die Oberfläche der Schnittstellenlagerung 106 ist von insbesondere zumindest zwei und vorteilhaft von zumindest drei Seiten durch im Wesentlichen senkrecht zu der Oberfläche der Schnittstellenlagerung 106 ausgerichtete Randabschnitte begrenzt.

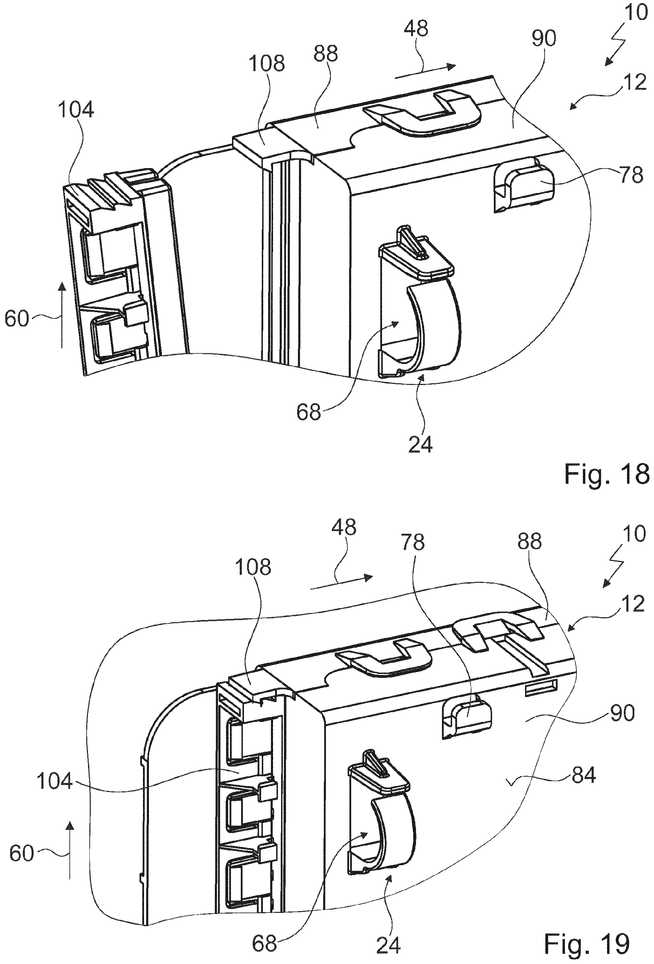

Bei einer Befestigung der weiteren Elektronikschnittstelle 104 an dem Grundkörper des Elektronikgehäuses 12 wird zunächst ein erstes Ende der weiteren Elektronikschnittstelle 104 in die Schnittstellenlagerung 106 eingesetzt (vgl. Fig. 16). In dieser Stellung ist die weitere Elektronikschnittstelle 104 schräg relativ zu dem Grundkörper des Elektronikgehäuses 12 ausgerichtet. Das Elektronikgehäuse 12 weist ein Rastelement 108 auf, das in dem montierten Zustand die weitere Elektronikschnittstelle 104 an dem Grundkörper des Elektronikgehäuses 12 verrastet. In der Stellung, in der die weitere Elektronikschnittstelle 104 schräg relativ zu dem Grundkörper des Elektronikgehäuses 12 ausgerichtet ist, wird ein dem ersten Ende gegenüberliegendes zweites Ende der weiteren Elektronikschnittstelle 104 in Richtung des Grundkörpers des Elektronikgehäuses 12 bewegt, und zwar insbesondere in Richtung des Rastelements 108. Diese Bewegung wird so lange fortgeführt, bis die weitere Elektronikschnittstelle 104 und das Rastelement 108 miteinander verrasten (vgl. Fig. 18 und 19).

Die Befestigungseinheit 26 ist dazu vorgesehen, das Elektronikgehäuse 12 an einer Vielzahl verschiedener Serien an dem Haushaltsgerätegehäuse 28 zu befestigen. Alternativ könnte die Befestigungseinheit dazu vorgesehen sein, das Elektronikgehäuse an verschiedenen Positionen desselben Haushaltsgerätegehäuses zu befestigen.

Beispielsweise könnte das Elektronikgehäuse zunächst an dem Boden des Haushaltsgerätegehäuses befestigt werden. Anschließend könnte beispielsweise jedoch vorgesehen werden, das Elektronikgehäuse, beispielsweise aus Platzgründen, an der Seitenwand des Haushaltsgerätegehäuses zu befestigen. Zunächst könnte hierbei das Elektronikgehäuse von dem Boden gelöst werden, wobei insbesondere das Grundbefestigungsmittel von dem Grundbefestigungselement und damit insbesondere von dem Elektronikgehäuse gelöst werden könnte. Anschließend könnte eine Abdeckung von dem Elektronikgehäuse gelöst werden (vgl. Fig. 4 und 5). Zur Befestigung an der Seitenwand könnte das Elektronikgehäuse um 180° gedreht werden. Diese Drehung könnte um eine Drehachse erfolgen, welche im Wesentlichen parallel zu der zweiten Richtung ausgerichtet ist (vgl. Fig. 5 und 6).

Das Elektronikgehäuse könnte wenigstens ein zusätzliches Anschlusselement aufweisen, das dazu vorgesehen sein könnte, weitere Gehäuse und/oder Einheiten an dem Elektronikgehäuse zu befestigen. Beispielsweise könnte das Elektronikgehäuse zumindest ein zusätzliches Anschlusselement und zumindest ein weiteres zusätzliches Anschlusselement aufweisen, welche insbesondere anlog zu dem Anschlusselement und dem weiteren Anschlusselement des Elektronikgehäuses ausgebildet sein könnten. Als weitere Gehäuse und/oder Einheiten könnten insbesondere ein Kühler und/oder eine Steuereinheit und/oder vorteilhaft ein Lüfter vorgesehen sein.

### Bezugszeichen

- 10: Haushaltsgerätevorrichtung
- 12: Elektronikgehäuse
- 14: Anschlusselement
- 16: Weiteres Elektronikgehäuse
- 18: Weiteres Anschlusselement
- 20: Kontaktelement
- 22: Führungselement
- 24: Weiteres Führungselement
- 26: Befestigungseinheit
- 28: Haushaltsgerätegehäuse
- 30: Grundbefestigungselement
- 32: Seitbefestigungselement
- 34: Boden
- 36: Seitenwand
- 38: Haushaltsgerät
- 40: Gerätetür
- 42: Türgriff
- 44: Vertikale Richtung
- 46: Maschinenraum
- 48: Erste Richtung
- 50: Anschlussmittel
- 52: Erste Aufnahmeöffnung
- 54: Erste Oberfläche
- 56: Zweite Oberfläche
- 58: Weiteres Kontaktelement
- 60: Zweite Richtung
- 62: Zweite Aufnahmeöffnung
- 64: Erster Führungsabschnitt
- 66: Zweiter Führungsabschnitt
- 68: Führungsöffnung
- 70: Elektronikschnittstelle
- 72: Weiteres Grundbefestigungselement
- 74: Seitbefestigungsaufnahme
- 76: Seitbefestigungsmittel
- 78: Weiteres Seitbefestigungselement
- 80: Grundbefestigungslagerung
- 82: Weitere Öffnung
- 84: Weitere Erste Oberfläche
- 86: Weitere Zweite Oberfläche
- 88: Erstes Gehäuseteil
- 90: Zweites Gehäuseteil
- 92: Gehäuseabdeckung
- 94: Grundbefestigungsmittel
- 96: Erstes Gehäusebauteil
- 98: Zweites Gehäusebauteil
- 100: Nut
- 102: Weitere Nut
- 104: Weitere Elektronikschnittstelle
- 106: Schnittstellenlagerung
- 108: Rastelement

## Patentansprüche

1. Haushaltskältegerätevorrichtung, mit zumindest einem Elektronikgehäuse (12) und zumindest einem weiteren Elektronikgehäuse (16), wobei das zumindest eine Elektronikgehäuse (12) zumindest ein Anschlusselement (14) aufweist, das dazu vorgesehen ist, das zumindest eine weitere Elektronikgehäuse (16) an dem zumindest einen Elektronikgehäuse (12) zu befestigen, und das zumindest eine Elektronikgehäuse (12) dazu vorgesehen ist, in wenigstens einem montierten Zustand das zumindest eine weitere Elektronikgehäuse (16) wenigstens teilweise zu tragen, weiterhin mit zumindest einer elektrischen Leitung, wobei das Elektronikgehäuse (12) eine erste Oberfläche (54) aufweist, die dem weiteren Elektronikgehäuse (16) zugewandt ist, und wobei das weitere Elektronikgehäuse (16) eine zweite Oberfläche (56) aufweist, die dem Elektronikgehäuse (12) zugewandt ist, **dadurch gekennzeichnet, dass** das zumindest eine Elektronikgehäuse (12) zumindest ein Führungselement (22) aufweist, das dazu vorgesehen ist, in dem wenigstens einen montierten Zustand die zumindest eine elektrische Leitung durch einen Zwischenraum zwischen der ersten Oberfläche (54) und der zweiten Oberfläche (56) zwischen dem zumindest einen Elektronikgehäuse (12) und dem zumindest einen weiteren Elektronikgehäuse (16) hindurchzuführen, wodurch eine geschützte Anordnung der zumindest einen elektrischen Leitung erreicht wird, wobei das Führungselement (22) eine Führungsbahn ausbildet, die einen Verlauf der zumindest einen elektrischen Leitung definiert und wobei das Führungselement (22) zumindest eine Oberfläche aufweist, die in dem wenigstens einen montierten Zustand der zumindest einen elektrischen Leitung zugewandt ist und wobei die zumindest eine elektrische Leitung in dem wenigstens einen montierten Zustand die Oberfläche wenigstens abschnittsweise berührt.

2. Haushaltskältegerätevorrichtung nach Anspruch 1, **dadurch gekennzeichnet, dass** das zumindest eine Elektronikgehäuse (12) zumindest ein weiteres Anschlusselement (18) aufweist, das zu dem zumindest einen Anschlusselement (14) beabstandet angeordnet und dazu vorgesehen ist, das zumindest eine weitere Elektronikgehäuse (16) in dem wenigstens einen montierten Zustand wenigstens teilweise aufzunehmen.

3. Haushaltskältegerätevorrichtung nach Anspruch 2, **dadurch gekennzeichnet, dass** das zumindest eine weitere Elektronikgehäuse (16) zumindest ein Kontaktelement (20) aufweist, das dazu vorgesehen ist, in dem wenigstens einen montierten Zustand wenigstens teilweise durch das zumindest eine weitere Anschlusselement (18) hindurchzugreifen.

4. Haushaltskältegerätevorrichtung nach einem der vorhergehenden Ansprüche, **dadurch gekennzeichnet, dass** das zumindest eine Elektronikgehäuse (12) zumindest ein weiteres Führungselement (24) aufweist, das dazu vorgesehen ist, in dem wenigstens einen montierten Zustand zumindest eine weitere elektrische Leitung zwischen dem zumindest einen Elektronikgehäuse (12) und einem Haushaltsgerätegehäuse (28) hindurchzuführen.

5. Haushaltskältegerätevorrichtung nach einem der vorhergehenden Ansprüche, **dadurch gekennzeichnet, dass** das zumindest eine Elektronikgehäuse (12) eine Befestigungseinheit (26) aufweist, die dazu vorgesehen ist, das zumindest eine Elektronikgehäuse (12) in dem wenigstens einen montierten Zustand an zumindest einem Haushaltsgerätegehäuse (28) zu befestigen.

6. Haushaltskältegerätevorrichtung nach Anspruch 5, **dadurch gekennzeichnet, dass** die Befestigungseinheit (26) zumindest ein Grundbefestigungselement (30) aufweist, das dazu vorgesehen ist, das zumindest eine Elektronikgehäuse (12) in dem wenigstens einen montierten Zustand an einem Boden (34) eines Haushaltsgerätegehäuses (28) zu befestigen.

7. Haushaltskältegerätevorrichtung nach Anspruch 5 oder 6, **dadurch gekennzeichnet, dass** die Befestigungseinheit (26) zumindest ein Seitbefestigungselement (32) aufweist, das dazu vorgesehen ist, das zumindest eine Elektronikgehäuse (12) in dem wenigstens einen montierten Zustand an einer Seitenwand (36) eines Haushaltsgerätegehäuses (28) zu befestigen.

8. Haushaltskältegerätevorrichtung nach einem der vorhergehenden Ansprüche, **dadurch gekennzeichnet, dass** das zumindest eine Elektronikgehäuse (12) zumindest zweiteilig ausgebildet ist.

9. Haushaltskältegerät, mit zumindest einer Haushaltskältegerätevorrichtung nach einem der vorhergehenden Ansprüche.

10. Verfahren zur Montage zumindest einer Haushaltskältegerätevorrichtung nach einem der Ansprüche 1 bis 8, bei welchem das zumindest eine Elektronikgehäuse (12) an zumindest einem Haushaltsgerätegehäuse (28) befestigt wird und anschließend das zumindest eine weitere Elektronikgehäuse (16) an dem zumindest einen Elektronikgehäuse (12) befestigt wird.

## Claims

1. Household refrigeration appliance apparatus, with at least one electronics housing (12) and at least one further electronics housing (16), wherein the at least one electronics housing (12) has at least one connection element (14), which is provided to fasten the at least one further electronics housing (16) to the at least one electronics housing (12), and in at least one assembled state the at least one electronics housing (12) is provided to at least partially carry the at least one further electronics housing (16), furthermore with at least one electrical line, wherein the electronics housing (12) has a first surface (54) which faces towards the further electronics housing (16), and wherein the further electronics housing (16) has a second surface (56) which faces towards the electronics housing (12), **characterised in that** the at least one electronics housing (12) has at least one guide element (22), which in the at least one assembled state is provided to guide the at least one electrical line through an intermediate space between the first surface (54) and the second surface (56), between the at least one electronics housing (12) and the at least one further electronics housing (16), whereby a protected arrangement of the at least one electrical line is achieved, wherein the guide element (22) embodies a guide path which defines a course of the at least one electrical line and wherein the guide element (22) has at least one surface, which in the at least one assembled state faces towards the at least one electrical line, and wherein in the at least one assembled state the at least one electrical line is in contact with the surface, at least in sections.

2. Household refrigeration appliance apparatus according to claim 1, **characterised in that** the at least one electronics housing (12) has at least one further connection element (18), which is arranged at a distance from the at least one connection element (14) and in the at least one assembled state is provided to at least partially accommodate the at least one further electronics housing (16).

3. Household refrigeration appliance apparatus according to claim 2, **characterised in that** the at least one further electronics housing (16) has at least one contact element (20), which in the at least one assembled state is provided to at least partially reach through the at least one further connection element (18).

4. Household refrigeration appliance apparatus according to one of the preceding claims, **characterised in that** the at least one electronics housing (12) has at least one further guide element (24), which in the at least one assembled state is provided to guide at least one further electrical line through between the at least one electronics housing (12) and a household appliance housing (28).

5. Household refrigeration appliance apparatus according to one of the preceding claims, **characterised in that** the at least one electronics housing (12) has a fastening unit (26), which in the at least one assembled state is provided to fasten the at least one electronics housing (12) to at least one household appliance housing (28).

6. Household refrigeration appliance apparatus according to claim 5, **characterised in that** the fastening unit (26) has at least one base fastening element (30), which in the at least one assembled state is provided to fasten the at least one electronics housing (12) to a base (34) of a household appliance housing (28).

7. Household refrigeration appliance apparatus according to claim 5 or 6, **characterised in that** the fastening unit (26) has at least one side fastening element (32), which in the at least one assembled state is provided to fasten the at least one electronics housing (12) to a side wall (36) of a household appliance housing (28).

8. Household refrigeration appliance apparatus according to one of the preceding claims, **characterised in that** the at least one electronics housing (12) is embodied at least in two parts.

9. Household refrigeration appliance, with at least one household refrigeration appliance apparatus according to one of the preceding claims.

10. Method for assembling at least one household refrigeration appliance apparatus according to one of claims 1 to 8, in which the at least one electronics housing (12) is fastened to at least one household appliance housing (28) and subsequently the at least one further electronics housing (16) is fastened to the at least one electronics housing (12).

## Revendications

1. Dispositif pour appareil frigorifique électroménager, comprenant au moins un boîtier électronique (12) et au moins un autre boîtier électronique (16), dans lequel le au moins un boîtier électronique (12) comprend au moins un élément de connexion (14) servant à fixer le au moins un autre boîtier électronique (16) au au moins un boîtier électronique (12), et le au moins un boîtier électronique (12) sert à supporter au moins partiellement, dans au moins un état assemblé, le au moins un autre boîtier électronique (16), comprenant de plus au moins une ligne électrique, le boîtier électronique (12) comprenant une première surface (54) tournée vers l'autre boîtier électronique (16), et l'autre boîtier électronique (16) comprenant une deuxième surface (56) tournée vers le boîtier électronique (12), **caractérisé en ce que** le au moins un boîtier électronique (12) comprend au moins un élément de guidage (22) servant à conduire, dans le au moins un état assemblé, la au moins une ligne électrique à travers un espace intermédiaire entre la première surface (54) et la deuxième surface (56) entre le au moins un boîtier électronique (12) et le au moins un autre boîtier électronique (16), ce qui fait que la au moins une ligne électrique se voit ainsi protégée, l'élément de guidage (22) réalisant une voie de guidage définissant un parcours pour la au moins une ligne électrique et l'élément de guidage (22) comprenant au moins une surface tournée, dans le au moins un état assemblé, vers la au moins une ligne électrique, et la au moins une ligne électrique touchant, dans le au moins un état assemblé, la surface au moins sur une partie.

2. Dispositif pour appareil frigorifique électroménager selon la revendication 1, **caractérisé en ce que** le au moins un boîtier électronique (12) comprend au moins un autre élément de connexion (18) se trouvant écarté du au moins un élément de connexion (14) et servant à loger au moins en partie le au moins un autre boîtier électronique (16) dans le au moins un état assemblé.

3. Dispositif pour appareil frigorifique électroménager selon la revendication 2, **caractérisé en ce que** le au moins un autre boîtier électronique (16) comprend au moins un élément de contact (20) servant à aller se prendre, dans le au moins un état assemblé, au moins en partie, dans le au moins un autre élément de connexion (18).

4. Dispositif pour appareil frigorifique électroménager selon l'une des revendications précédentes, **caractérisé en ce que** le au moins un boîtier électronique (12) comprend au moins un autre élément de guidage (24) servant à conduire, dans le au moins un état assemblé, au moins une autre ligne électrique entre le au moins un boîtier électronique (12) et un bâti d'appareil électroménager (28).

5. Dispositif pour appareil frigorifique électroménager selon l'une des revendications précédentes, **caractérisé en ce que** le au moins un boîtier électronique (12) comprend une unité de fixation (26) servant à fixer le au moins un boîtier électronique (12), dans le au moins un état assemblé, au au moins un bâti d'appareil électroménager (28).

6. Dispositif pour appareil frigorifique électroménager selon la revendication 5, **caractérisé en ce que** l'unité de fixation (26) comprend au moins un élément de fixation au sol (30) servant à fixer le au moins un boîtier électronique (12), dans le au moins un état assemblé, à un plancher (34) du bâti de l'appareil électroménager (28).

7. Dispositif pour appareil frigorifique électroménager selon la revendication 5 ou 6, **caractérisé en ce que** l'unité de fixation (26) comprend au moins un élément de fixation latéral (32) servant à fixer le au moins un boîtier électronique (12), dans le au moins un état assemblé, à une paroi latérale (36) du bâti de l'appareil électroménager (28).

8. Dispositif pour appareil frigorifique électroménager selon l'une des revendications précédentes, **caractérisé en ce que** le au moins un boîtier électronique (12) est réalisé en au moins deux parties.

9. Appareil frigorifique électroménager comprenant au moins un dispositif pour appareil frigorifique électroménager selon l'une des revendications précédentes.

10. Procédé d'assemblage d'au moins un dispositif pour appareil frigorifique électroménager selon l'une des revendications 1 à 8, dans lequel le au moins un boîtier électronique (12) se fixe à au moins un bâti d'appareil électroménager (28), et qu'ensuite le au moins un autre boîtier électronique (16) se fixe au au moins un boîtier électronique (12).
